# EUROPEAN PATENT SPECIFICATION

(11) **EP 1 354 274 B1**
(45) Date of publication and mention of the grant of the patent: **11.06.2008**
(21) Application number: 02732091.0
(22) Date of filing: 15.01.2002
(51) Int. Cl.: G06F 13/00

(54) **SERIAL LINK ARCHITECTURE**
SERIELLE VERBINDUNGSARCHITEKTUR
ARCHITECTURE DE LIAISON SERIE

(30) Priority: 16.01.2001 US 262401 P; 28.11.2001 US 996113
(43) Date of publication of application: 22.10.2003
(73) Proprietor: International Business Machines Corporation, Armonk, NY 10504 (US)
(72) Inventor: CRANFORD, Hayden, Clavie, Apex, NC 27502 (US); NORMAN, Vernon, Roberts, Cary, NC 27511 (US); SCHMATZ, Martin, Leo, CH-9012 St Gallen (CH)
(74) Representative: Litherland, David Peter
(86) International application number: PCT/GB2002/000123
(87) International publication number: WO 2002/057924

(56) References cited:
- EP-A- 0 614 281
- US-A- 5 844 436
- US-A- 5 982 836

## Description

### FIELD OF THE INVENTION

The present invention relates to the logic architecture that provides the digital functions required to enable a unified, unidirectional serial link across wired media, such as a chip-to-chip or a card-to-card interconnect.

### BACKGROUND OF THE INVENTION

Serial data must be transmitted across wired media. The transmit and receive sections include chips wired to one another and card-to-card interconnects. The transmission media can be a combination of printed circuit board, connectors, backplane wiring, fiber or cable. The interconnect can include its own power, data and clocking sources or may derive these functions from a host module. Such data has typically been transmitted through a parallel data bus, such as ISA, PCI, PCI-X and the like. One drawback of such parallel links is the moderate rate of data transmission due to improved microprocessor performance, resulting in data transfer bandwidths that typically outpace I/O transfer rates. Also, the ASIC I/O count is high. In addition, the system integration I/O count using a parallel data bus is high. Finally, the overall system cost associated with the use of the parallel data bus tends to be high.

Related art shows attempts to overcome these difficulties and drawbacks by utilizing serial communication systems involving a variety of schemes. For example, some have used a carrierless amplitude/phase (CAP) modulation scheme. Others have used linear compression/decompression and digital signal processing techniques for frequency modulation. Still others use a linear (analog) phase rotator to recover only the carrier of an incoming signal. Some transmit using a pass band which limits the bandwidth of the frequencies being passed, rather than a baseband channel wherein the signals are not shared and the frequencies are not restricted.

EP-A-0614281 describes a digital high speed data recovery technique including a transmitter and a receiver, the receiver including a PLL control circuit and an oversampled half-rate system comprising a signal edge comparator, an early/late signal generator based on the output of the comparator, and a multi-step phase rotator controlled by the generated signal.

### BRIEF DESCRIPTION OF THE INVENTION

According to one aspect of the present invention there is provided a unified serial link system for transmitting digital data across wired media including a transmitter and a receiver, the receiver including a phase locked loop control circuit and an over sampled half-rate system comprising a signal edge comparator, an early/late signal generator based on the output of the comparator, and a multi-step phase rotator controlled by the generated signal; characterised by the transmitter comprising a dual loop phase locked loop (PLL) control circuit having a digital coarse loop for providing a PLL frequency control signal to an analog fine loop, the analog fine loop providing a stable clock for transmitting the digital data.

According to a second aspect of the present invention there is provided a method of transmitting digital data across wired media between a transmitter and a receiver, comprising: providing a transmitter with a phase locked loop (PLL) control circuit having a digital coarse loop and an analog fine loop; providing a PLL frequency control signal from the coarse loop to an analog fine loop the analog fine loop providing a stable clock for transmitting the digital data; and providing a receiver including a phase locked loop control circuit and providing an over sampled half-rate system comprising a signal edge comparator, an early/late signal generator based on the output of the comparator, and a multi-step phase rotator controlled by the generated signal.

A unified digital architecture comprises a logic transmitter portion and logic receiver portion. The logic transmitter portion contains a phase locked loop (PLL), a dibit data register, a finite impulse response (FIR) filter and a transmit data register. It also uses a pseudo-random bit stream (PRBS) generator and checker. The digital receiver portion contains a PLL, a FIR phase rotator, a phase rotator control state machine and a clock buffer. It can also include a pseudo-random bit stream (PRBS) generator and a checker for diagnostics.

The invention comprises a unified serial link system and method for transmitting digital data across wired media including a transmitter and a receiver. The transmitter PLL comprises a dual loop phase locked loop control circuit having a digital coarse loop and an analog fine loop. The transmitter PLL contains a four-stage voltage controlled oscillator adapted to run at full bit frequency. The coarse loop includes a reference generator, a voltage comparator, a PLL control logic, a digital to analog counter and a low pass filter. The fine loop includes the oscillator, a 4X-frequency divider, a phase-frequency detector, a charge pump and a loop filter. The transmitter contains a random bit stream generator. The receiver includes a dual loop PLL phase locked loop control circuit and an over sampled half-rate system with a multi-step phase rotation, controlled by a signal generated by an early/late comparator.

### DESCRIPTION OF THE DRAWINGS

Figure 1 is a high level diagram showing a wired interconnection between a transmitter portion and a receiver portion of a serial link;
Figure 2 is a block diagram showing the operation of the circuitry of the transmitter portion of the architecture;
Figure 3 is a block diagram showing the operation of the circuitry of the receiver portion of the architecture;
Figure 4 is an illustration of the control circuit for a phased lock loop;
Figure 5 is a block diagram of a transmitter architecture;
Figure 6 is a block diagram of a receiver architecture;
Figure 7 shows an averaging pattern for a phase rotator control;
Figure 8 shows another embodiment of an averaging pattern for a phase rotator control;
Figure 9 is a block diagram of a transmitter architecture;
Figure 10 is a schematic diagram of a loop filter;
Figure 11 is a schematic of a transmit VCO;
Figure 12 is a schematic of a transmit VCO delay cell;
Figure 13 is a block diagram of a receiver architecture;
Figure 14 is a schematic view of a receiver circuit;
Figure 15 is a schematic view of a differential amplifier;
Figure 16 is a schematic diagram of a receive sampling latch;
Figure 17 is a schematic of a receive VCO;
Figure 18 is a schematic diagram of a latch buffer;
Figure 19 is a schematic diagram of an inverter buffer;
Figure 20 is block diagram of another embodiment of a dual loop PLL;
Figure 21 is a block diagram of the coarse loop of Figure 20;
Figure 22 is a block diagram of the topography of a phase rotator and phase buffer;
Figure 23 is a schematic diagram of a phase rotator cbias;
Figure 24 is a schematic diagram of a phase rotator currents buffer;
Figure 25 is a block diagram of a phase rotator currents buffer six pack;
Figure 26 is a schematic diagram of a phase rotator currents buffer array;
Figure 27 is a block diagram of a phase rotator core circuit six pack;
Figure 28 is a schematic diagram of a phase rotator core circuit;
Figure 29 is a schematic diagram of a phase rotator core buffer circuit;
Figure 30 is a schematic diagram of a phase rotator core buffer post-buffer circuit;
Figure 31 is a block diagram of another embodiment featuring a basic FIR filter approach with an eight stage/phase ring oscillator;
Figure 32 is a graphical representation of the stepwise change of output phase by a phase rotator;
Figure 33 is a simplified schematic for a six phase version of a phase rotator; and
Figure 34 provides a detail view of one of a circuit block of the phase rotator of Figure 33.

### DESCRIPTION WITH REFERENCE TO THE DRAWINGS

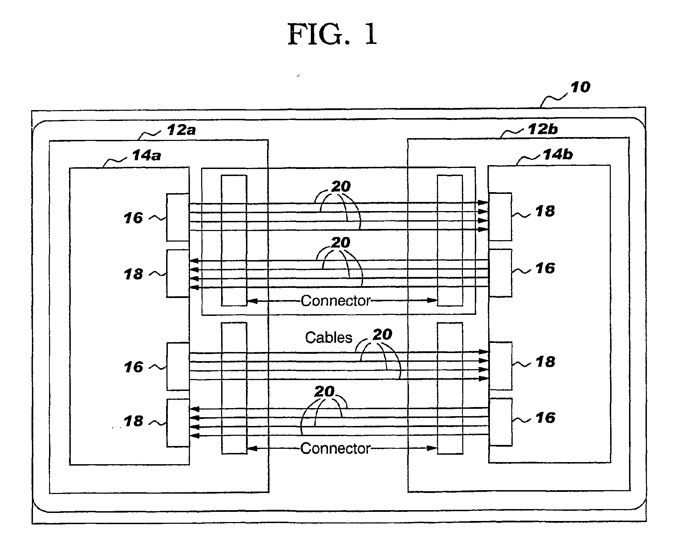

Referring now to the drawings and, for the present, to Figure 1, a high level diagram of interconnection of ASICs showing a transmitter on one side of the connection and a receiver on the other side of the connection for several different transmitter and receivers for passing information is shown. The embodiment can be implemented in any one of several different configurations, such as a combination of a printed circuit boards, connectors, back plane wiring, fiber or cable. As shown, the implementation will be on a back plane with hard wiring between the transmitting portion and the receiving portion.

As can be seen in Figure 1, a back plane 10 is provided which has mounted thereon a pair of printed circuit (PC) cards 12a and 12b. Each circuit card 12a and 12b is provided with, respectively, ASIC chips 14a and 14b which are to be interconnected. Each ASIC 14a, 14b has at least one transmitter 16 and, as illustrated, has two such transmitters, although more can be provided. Also, each ASIC 14a, 14b is provided with at least one receiver 18; again, the illustrated embodiment shows two receivers 18, although, as indicated above with respect to the transmitter 16, more than two can be provided. Generally speaking, the transmitter 16 and receiver 18 are provided in pairs since data generally will have to flow in both directions and the connection described herein is unidirectional. Each transmitter 16 on ASIC 14a or 14b includes one-way hard wired serial buses 20 interconnecting the transmitter 16 on one ASIC 14a or 14b to a receiver 18 on the other ASIC 14a or 14b. Thus, two-way communication is provided by having paired transmitters and receivers on each ASIC 14a or 14b.

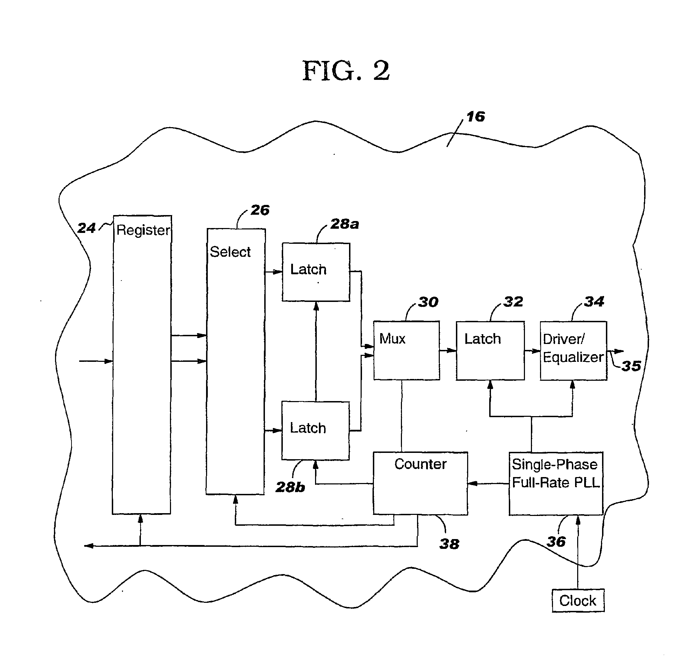

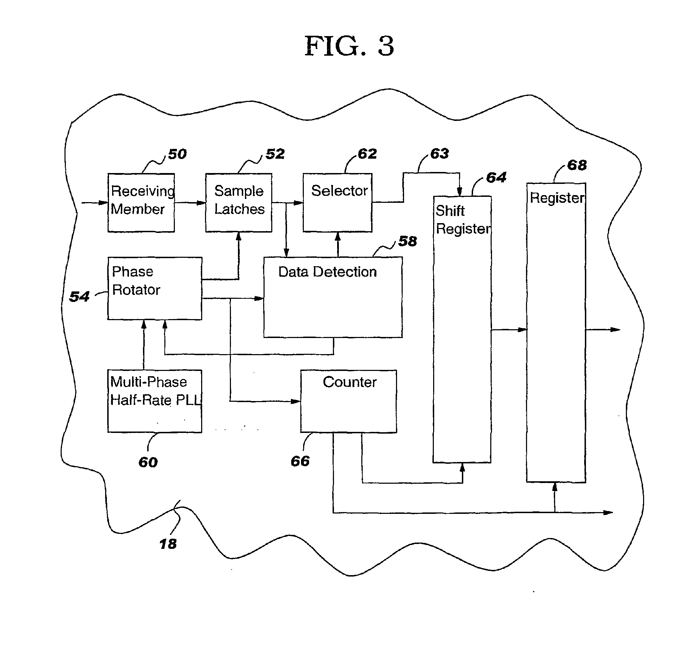

Briefly, each transmitter 16 has stored therein parallel digital data in a register 24 (Fig. 2). The transmitter 16 converts this stored, parallel, digital data in the register 24 in one ASIC, eg. 14a, to serial analog form, transmits the data in serial analog form on one of the serial buses 20 to the receiver 18 associated therewith on the opposite ASIC, eg. 14b. The receiver 18 converts the analog asynchronous serial data to synchronous, parallel, digital data for storage 68 (Figure 3) in a register in digital form.

Thus, the function of the serial link herein is to take parallel data in a register in an efficient manner, transmit it in an asynchronous serial analog form and reconvert it to synchronous, parallel, digital data.

Referring now to Figure 2, a block diagram of the circuitry function of a transmitter 16 is shown. As can be seen, the transmitter 16 includes a bit register 24. Typically, this is either an eight-bit or a ten-bit register, although other size registers could be used. The description of this particular register 24 will be as a ten-bit register. A two-bit of ten bit selector 26 is provided which will select two bits at a time sequentially from the register 24. This is done under the synchronous control of counter 38. It is to be understood that other than two bits at a time can be read from the register 24. However, this number must be a number that is evenly divisible into the number of bits in the register 24. Thus, in the case of a ten-bit register, this could be one, two or five and, in the case of an eight-bit register, this could be one, two or four. Two bits are preferred.

Each of the two bits selected by the selector 26 from the register 24 is provided to a bit latch 28a or 28b. This selection and delivery is also under the synchronous control of counter 38. The bits are then delivered from the latches 28a and 28b to a multiplexor 30, also under the synchronous control of counter 38, and then to a one-bit latch 32. From the one-bit latch 32, the bits are delivered to a driver equalizer 34, which will convert the received digital bits from the latch 32 to a serial analog signal output 35 containing the converted digital bits.

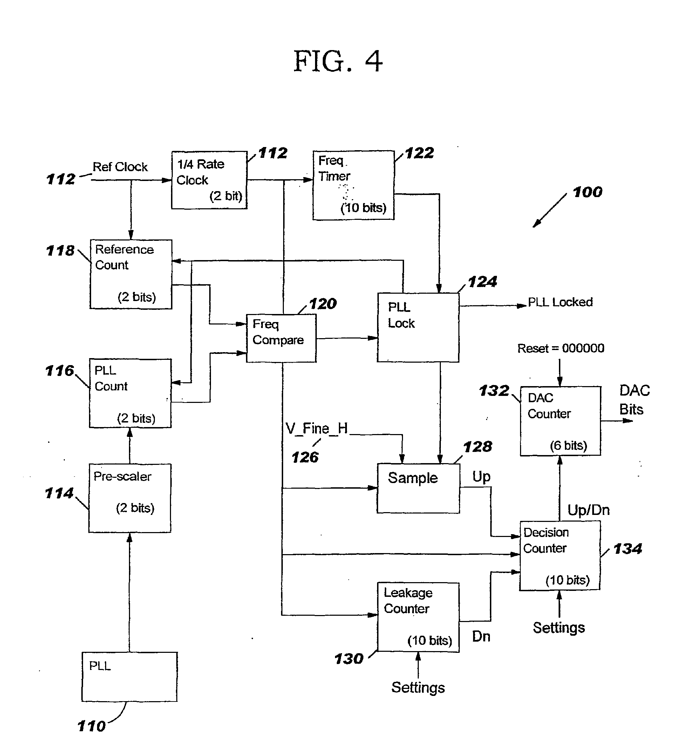

A single phase, full rate, phase lock loop 36 is provided which will clock the action of the latch 32 and driver equalizer 34, and also will actuate the counter 38 which, in turn, has inputs to the multiplexor 30, the latches 28a and 28b, the select 26 and the ten-bit register 24. The phase lock loop 36 has as an input thereto a clock signal, which can be internal or external from clock 40, as shown. The counter 38 functions to provide synchronous operation of the extraction of the bits from the register 24 by the selector 26 for delivery to the latches 28a and 28b. Also, the counter operates to form a synchronous delivery of the bits from the latches 28a and 28b to the multiplexor 30 and therefrom to the latch 32. It is at the driver equalizer 34 that the digital bits synchronously received are converted to a serial analog signal 35. The functioning and more detailed description of the various parts of the transmitter 16, such as the bit register 24, selector 26, the latches 28a and 28b, the multiplexor 30, the latch 32, the single phase, full rate, phase lock loop 36 and the counter 38 are all described hereinafter in more detail with reference to Figures 4 to 34. The analog output 35 is placed on the serial bus 20. It is transmitted in an asynchronous form to the receiver 18 attached to the other end of the serial bus 20. As indicated above, the receiver 18 receives the asynchronous analog signal and converts it to a synchronous digital parallel signal corresponding to the digital bits in register 24 for storage in the receiver 18.

Referring now to Figure 3, a block diagram showing the structure and circuitry function for converting the asynchronous analog serial signal 35 to a synchronous digital parallel digital bits for storage in the receiver 18 for storing bits is shown. The serial analog asynchronous signal 35 is received by a signal receiving member 50 which delivers the analog signal to sample latches 52. In the sample latches 52, the analog signal is converted to a digital signal by means of a phase rotator 54 which operates under the control of a data detection and edge detection circuit 58 and a multi-phase, half rate phase lock loop 60. This technique operates by sampling, and preferably multiple sampling, both edges of the data in the analog signal and converts the data in the analog signal to parallel data bits. Preferably, the multiple samples are used to determine the approximate center point of each resulting data bit. This is an oversampling circuit which will convert the asynchronous analog serial signal in selector 62 to a digital output 63 in two-bit increments delivered to a shift register 64. A counter 66, which is actuated by the phase rotator 54, operates on shift register 64 to output the two-bit digital signals as ten-bit synchronous signals to ten-bit register 68. The operation of this receiver 18 is described hereinafter in detail with relation to Figures 4 to 34.

Thus, the ten-bit digital bits stored as parallel data in the ten-bit register 24 are converted by the transmitter 16 to an asynchronous analog serial signal 35 which is to be transported asynchronously on bus 20, which asynchronous analog signal 35 is then reconstituted by the receiver 18 to the original ten-bit parallel digital bit in register 68.

As explained hereinafter with respect to Figures 4 to 8, the transmitter PLL 36 and the receiver PLL 60 are each provided as a dual loop phase locked loop control circuit having a digital coarse loop and an analog fine loop.

The PLL control architecture is intended to provide the coarse PLL control loop for a dual-loop PLL. Lock is determined by comparing two Grey counters running on reference and PLL clocks. Digital to analog conversion (DAC) bits, which set the coarse control voltage for the PLL, are controlled by monitoring a signal from the PLL (V_Fine_H) which indicates which half of its operating range it is in. Figure 4 illustrates the PLL control circuit.

More specifically, Figure 4 shows a full data rate PLL 110. This PLL is the clock source for the transmitted data and runs at the full data rate of e.g. 2 to 3 Gbps. A stable frequency from a reference clock 112 is required for determining if the PLL is locked to its correct frequency. The clock 112 operates at one-fourth of the full data rate. For example, a 625 Mhz clock rate is used for an operational data rate of 2.5 Gbps. A single clock phase is buffered, is brought out of the PLL, and is used to drive into a phase buffer circuit.

The PLL contains a four-stage voltage controlled ring oscillator (VCO), a 4X frequency divider, phase-frequency detector, charge pump and loop filter. These elements form the "fine" control loop. The VCO has both a 'fine' analog and a 'coarse' digital control voltage in order to minimize the required gain of the fine loop. The VCO is capable of changing the speed of oscillation by adjusting the local feedback within a delay cell, as well as controlling feedback within the VCO for speed enhancement. In addition to the fine control loop elements, the PLL 110 contains a reference generator, a voltage comparator, PLL control logic, a low-pass filter and a digital to analog counter 132. These elements form the coarse control loop.

The fine control loop is a conventional analog loop and is intended to provide a stable, low-noise, low-jitter clock source for the transmitter. The details of the fine control loop are well known in the art and do not by themselves comprise any part of the present invention.

The coarse control loop is a digital representation of a conventional analog control loop based on a 'leaky' loop filter capacitor. This type of loop relies on leakage from a loop filter cap (capacitor) to drive the control voltage in a particular direction regardless of the frequency of the VCO. A phase detector and charge pump that only increases the charge on the filter cap compensates this leakage. The loop is stable when the charge being added to the cap balances the charge that is leaking.

A signal from the reference source 112 is fed into a reference counter 118. A pre scaler 114 divides to one-fourth the frequency from the PLL 110. A frequency comparator 120 matches the frequency from the PLL counter 116 with that of the reference counter 118 to determine if the divided by four PLL 110 output and the reference clock 112 are running at the same frequency and are counting at the same rate. The two counters 116, 118 are compared over a period of time, e.g. 10-bit count, as determined by the frequency timer 122. Over this 10-bit count, if the comparator determines that the counted values are maintaining a fixed distance from one another, the comparator 120 then confirms that the PLL 110 is locked. The PLL lock 124 monitors the output of the frequency timer. Every time the frequency timer 122 reaches its maximum count, the PLL counter 116 and the reference counter 118 are reset. Thus, this comparison is performed each time the frequency timer 122 times out. If, during the interval, the two counters 116, 118 have not compared to one another or the frequency comparator 120 has not become true, this assumes that the clocks are locked because the counters are not catching up with one another. If, however, the frequency timer 122 times out and a frequency comparator 120 has compared the reference count and the PLL count, it declares that the PLL is unlocked. These two counters are reset if the frequency timer 122 declares that the PLL is unlocked.

A V_fine_H signal 126 is introduced from the analog section of the transmitter and indicates that the fine loop is at the center of its range. When the PLL locks and the fine loop is centered, the signal can move up and down from the center with some degree of latitude. This then allows for perturbations of the system, such as temperature changes. The signals from the PLL and the fine loop are asynchronous and go to the sample latch 128. If the V_fine_H signal is not on and the PLL lock signal is not on, then an 'up' signal is applied. This causes the decision counter 134 to count up, thereby causing the DAC counter 132 to also count up. When both of these conditions are met, the system stops counting up.

The DAC counter is a binary search counter with 64 possible steps counting up from 000000 to 111111. The counter steps through all of the different settings until it finds a setting where the PLL will lock.

The PLL control logic in the coarse control loop has an up/down counter 130, the value of which represents the charge on the loop filter cap. This counter 130 is slowly decremented to represent leakage. The voltage comparator is high or low depending on whether the fine control voltage is operating in the upper or the lower half of its range. To balance the leakage, the control logic samples the comparator output. After multiple samples showing upper range operation, the up/down counter is incremented to represent adding charge to the loop filter cap. The DAC and low-pass filter convert the up/down counter output to a control voltage. The coarse control loop is intended to compensate for manufacturing process variations and relatively low frequency but large changes due to power supply and temperature drift.

The transmit phase buffer consists of circuits which are designed to interface to the pre-drive section of the PLL and provide only light loading to the PLL. The phase buffer then drives out to a latch providing the clock necessary for a full rate design. The phase buffer must also provide adequate rise and fall times, taking into account the estimated net loadings.

The driver/equalizer consists of current-mode differential drive circuits which are controlled by a finite impulse response (FIR) type filter function. This filter is implemented by the combination of a shift register containing the current outgoing data bit and a history of three previous bits. This shift register, in turn, controls the activation of weighted current drivers. The output transfer function is of the general form of H(Z) = Ab₀ + Ab_{1Z}⁻¹ + Ab₂Z⁻²+ Ab₃Z⁻³ wherein the values of the bₙ coefficients are negative. The numerical values of the coefficients are set by register values in the logic. The determining factors for the values of these coefficients include the characteristics of the transmission, media, the speed of transmission, the type of board connector used, the type of chip package, etc. The data bits are fed to the transmitter after the necessary conversion to the differential signal form and the powering up that is required to control the driver.

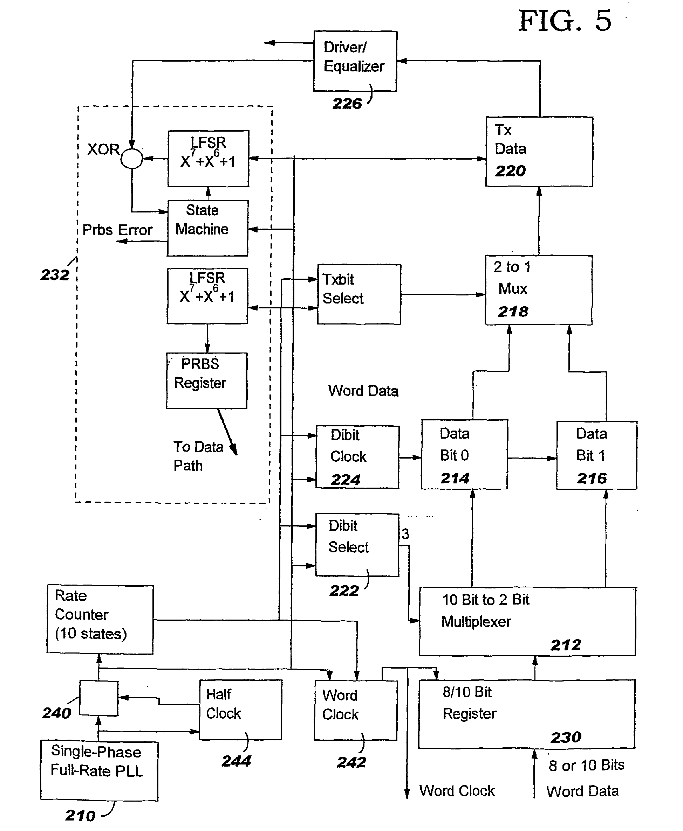

The transmitter architecture is a multiplexing full-rate system. It is supported by three major analog blocks: a full data rate PLL, a phase buffer to repower the PLL signal for the driver, and an off-chip driver with a built-in pre-emphasis equalization. In addition, there are specialized circuits for testing of the PLL. Figure 5 shows a block diagram of the transmitter architecture. A PLL 210 is controlling a four-stage ring oscillator 240 running at the full bit frequency. This PLL is shared by four transmitters. The phase outputs are used as local recovered clocks and to clock the FIR section of the driver. Word data (eight or ten bits) is clocked into a register synchronously with a word clock 242 generated from the PLL clock. The word data is transferred two bits at a time to a dibit data register 230 which is then loaded one bit at a time into the transmit data register. The final output is transferred at the full bit rate to the driver/equalizer block 226. The transmitter also contains a pseudo-random bit stream (PRBS) generator and checker 232, which allows for self-testing in a wrap mode as well as link testing with a corresponding receiver.

In more detail, the transmitter structure takes eight or ten bit data from the dibit data register 230 and synchronously transfers the data two bits at a time through a bit selector 212 to a first holding latch 214 and a second holding latch 216. The bit selector 212 processes the two bit data pair by the least significant bit first, followed by the next lower significant bit. The counter 222 tracks the number of pairs that are processed and the order of each bit in the pair. When the counter senses that all bit-pairs have been serialized, the interfacing logic is notified to send another word for processing and the eight bit/ten bit register is clocked to latch the new data to be processed. The contents of the first and second latches 214, 216 are transferred in an alternating fashion under the control of dibit clock 224 to a dibit data register 218 and then to a single latch 220. A bit stream from this single latch 220 is transmitted to a driver/equalizer 226. This device takes the bit stream and creates a current-mode differential signal that is frequency equalized for the assumed media channel. The equalization is a finite impulse response (FIR) pre-emphasis type using reduced current levels for longer run lengths.

The driver equalizer consists of current-mode differential drive circuits which are controlled by the FIR filter function commonly employed for this purpose. The filter is implemented by the combination of a shift register containing the current outgoing data bit and a history of the three most recent bits of outgoing data. The shift register, in turn, controls the activation of weighted current drivers.

The receiver architecture or core is a three-fold oversampled half-rate system with a 54-step phase rotator, advanced digital bang-bang control circuit and an implementation of a sample processing algorithm that centers the static edge in the middle between two samples. The receiver takes a signal, such as an NRZ encoded baseband signal, from a serially wired transmitter and aligns the edges to determine where the signal switches between '1's and '0's. As with other signals, the problem is placing the center point between the edges. This is a achieved by sampling the signal and generating early or late signals based on whether the signal is being sampled too early or too late. When the frequency of the early signals is more than that of the late signals, the system drifts in the 'early' direction. Conversely, it drifts in the 'late' direction when the frequency of the late signals is greater that that of the 'early' signals.

This present arrangement addresses the problem of incorrect decisions based on over-the-edge sampling by the use of oversampling which uses evenly spaced samples, but without placing a sample over the edge of the bit. Instead, this invention positions the samples so that no samples are on the bit edge, but instead samples are placed on either side of the edge. This method has a reduced probability of incorrectly predicting the position of the edge in the presence of random phase noise. This improvement directly affects BER (bit error rate) which is a primary goal of such systems.

The data is oversampled and a digital circuit detects the edge position in the data stream. This digital circuit not only selects the optimum data sample, but also generates early and late signals, if the detected edge is not at its expected position. No signal is generated if no edge is found. Three or more evenly spaced samples make fewer errors on detection of edge because it is not centered on the data edge and is less likely to make consecutive incorrect decisions. The receiver architecture is a three-fold oversampled half-rate system with a 54-step phase rotator and an algorithm, such as an adaptive sample processing algorithm, centering the bit edge in the middle between two samples.

A phase locked loop (PLL) controls a three-stage voltage controlled ring oscillator (VCO) running at half the bit frequency. Each stage includes a voltage controlled current source coupled to an n-type MOS (metal-oxide semiconductor) transistor. The current source is preferably a p-type MOS transistor. The oscillator is controlled by a voltage signal and by a current signal.

Each PLL can be shared by multiple receivers. The six phases from the VCO are fed into a phase rotator having 54 steps for a 2ö interval. The 54 steps are generated with a finite impulse response (FIR) phase rotator having six phases with three inter-slice phase steps that are further divided by three.

The six outputs of the rotator are buffered, and the edges are shaped to be able to sample a signal having twice the frequency. One of the phase outputs is used as a local recovery clock. A clock buffer makes sure that it is not loading the phase rotator too much. Logic timing analysis determines which phase is the optimum to use as the local recovery clock. The output section of the phase rotator suppresses common mode signals and performs a limiting signal.

The output is then driven out to the phase buffers (with the signals from the phase rotator) which, in turn, provides clocks. Six samples are taken over a two-bit interval. Three pipeline stages are added in order to reduce the probability of a metastable state to a value much lower than the targeted bit error rate. The stages also help to align the data to one single clock phase. In order to be able to process information from more than one bit interval for the recovery of one data bit, a memory stage re-uses four samples from the previous sampling period. A total of 10 samples are, therefore, fed into the half rate edge and data detection correlation blocks that make use of a pattern recognition algorithm.

The outputs of the edge and data detectors are the recovered two bit and the early and late signals going to the phase rotator control state machine. A bang-bang control circuit with adaptive step size is used for this purpose. The rotator counter and temperature code generator generates the 54 control signals for the phase rotator and this closes the CDR loop.

The data path consists of a shift register which loads two bits from the data correlation blocks during each half-rate cycle. The shift register is loaded to a word data register (8 or 10 bits) using a word clock derived from the PLL clock.

The receiver architecture is supported by four major analog elements, a half data rate PLL, a phase rotator, a phase buffer and a sample latch. The function of each of these elements will be described in more detail hereinafter. The data interface for each receiver link comprises an output data bus, a mode control bit, and an output data clock. The mode control bit determines if the receiver core is operating on an 8-bit or a 10-bit transmitter output.

The phase adjustment and clock recovery is done by a phase rotator, and not by using a DLL or PLL control loop. If there is more than one analog PLL or DLL on one chip, these circuits tend to interact via supply and/or substrate coupling. It would, therefore, be difficult to control their phases/delay in an analog fashion. The use of an independent PLL clock generator and an external phase rotator makes the system more immune to injected noise. The control of the phase shift is digital. The system operates at half the bit rate. For analysis of edges and data, however, three-bit intervals are used in order to have a half bit overlap on both sides. Some of the actual samples are reused in the analysis cycle described below. The rotator control state machine has a 'fly wheel' function. It monitors the phase update rate and applies an update even if no edge information is measured. This allows a TX to RX frequency offset even with a very long (>1024 bit) run length, if the jitter of the two clocks is small enough.

The receiver analyzes the oversampled data stream and generates two sets of correlation output signals, the detected bit values and the early and late signals, for an eventual update of the phase rotator. When the detected bit edge is centered between two samples, there is a 'dead-zone' in the CDR control loop if no jitter is present. With a jitter number larger than the sample spacing, the loop will average the detected sample crossings and will position the edge in the middle between two samples. This is a different situation than that found in a PLL phase detector with a dead zone, because the jitter is much larger and the phase control is digital with no leakage effects. The probability of generating a metastable sampling output is reduced for a middle edge position because the probability of an edge being positioned right on a sample is reduced.

The receiver structure performs clock and data recovery (CDR) on the incoming serial data stream. The quality of this operation is a dominant factor for the bit error rate (BER) performance of the system. In order to overcome the drawbacks of the conventional methods, feed forward and feedback controls are combined in one receiver architecture. The data is oversampled and a digital circuit detects the edge position in the data stream. This digital circuit not only selects the optimum data sample, but also generates an early or late signal, if the detected edge is not at its expected position. No signal is generated if no edge is found. The phase rotator control state machine processes the early and late signals from the edge correlation outputs to control the output phase settings of a multi-phase PLL in a feedback loop. This feedback loop takes care of low frequency jitter phenomenon of unlimited amplitude, while the feed forward section suppresses high frequency jitter having limited amplitude. The static edge position is held at a constant position in the oversampled data array by a constant adjustment of the sampling phases with the early and late signals.

In principle, the early/late signals can be used to directly control the output phase positions of a multiphase clock generator PLL. This would, however, dictate the use of one PLL per channel or receiver. If a phase rotator device is used to control the phase output of the clock generator, one PLL may be used for several receivers.

Figure 3 shows a phase rotator 54 which is a building block that accepts several input phases from a multiphase half rate PLL 60 and performs a simultaneous shift of all phases by a fixed number of degrees. In one adjustment step, only a given predetermined phase step may be accomplished in order to guarantee that no glitch occurs. The overall phase shift is unlimited (modulo 360 degrees) to allow 'round-robin' operation. This building block is part of a clock/data recovery phase locked loop in the conventional sense. Receiver 50 takes transmitted data and forwards it to sample latches 52. The digital data and edge detector 58 and the selector 62 select the optimal sample from the available samples to send to the deserializing shift register 64. The sample is then transferred to 8/10 bit data register 68. The counter 64 provides overall clocking of fractional rate logic within the design. In other words, it divides the half rate clock coming out of the PLL 60, and produces a quarter rate clock, as well as an eighth rate clock and a tenth rate clock

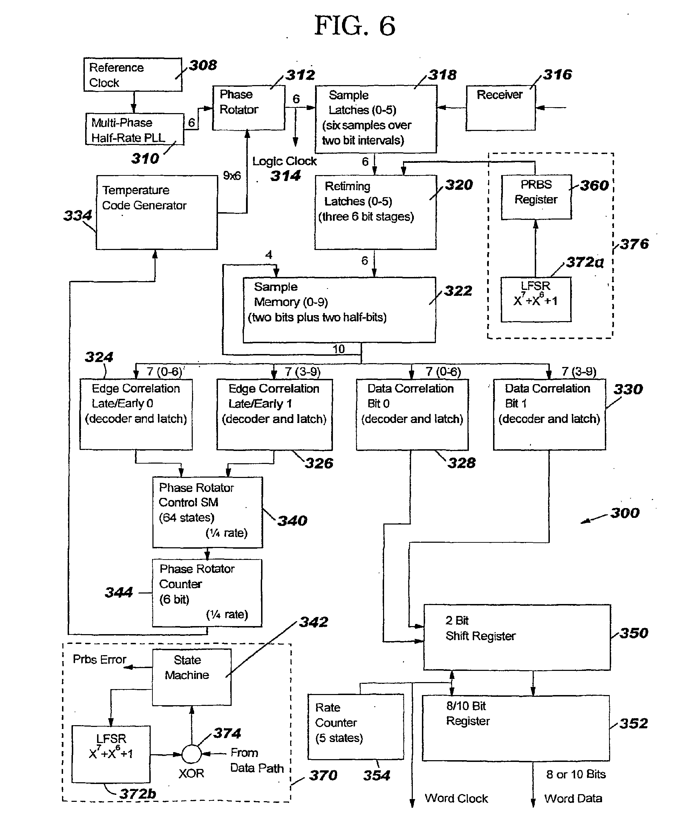

Figure 6 illustrates in greater detail a block diagram of the receiver architecture of the present invention. A phase locked loop (PLL) 310 receives a signal from a reference clock 308. The PLL includes and controls a voltage controlled three-stage ring oscillator (VCO) running at half the bit frequency. This PLL 310 is shared by four receivers, one 316 being shown. The six phases from the VCO are fed into a phase rotator 312 having 54 steps for a 2ö interval. The 54 steps are generated with a finite impulse response (FIR) phase rotator having six phases with three inter-slice phase steps that are further divided by three.

The six outputs of the rotator 312 are buffered, and the edges are shaped to be able to sample a signal having twice the frequency. One of the phase outputs is used as local recovered clock 314. A clock buffer (not shown) makes sure that it is not loading the phase rotator too much. Timing analysis determines which phase is the optimum to use. The output section of the phase rotator suppresses common mode signals and performs a limiting signal.

The output is then driven out (with the signals from the phase rotator) to the phase buffers and to a sample latch complex 318 which samples the incoming data. Six samples are taken over a two-bit interval. The sample latch complex is a CMOS, positive edge triggered latch. It takes differential data inputs and a single ended clock, and outputs a single ended, logic level signal. The complex consists of two circuits, the latch itself and a buffer that sharpens the output to the receive logic. The retiming latches 320 typically have a multiplexor (not shown) in front of them. This allows the latches to receive either sample latches 318 or input from the PRBS depending on whether data is being received from the receiver path or from the PRBS register 360. The pipeline stages from the PRBS register 360 reduce the probability of a metastable state to a value much lower than the targeted bit error rate. The retiming latches 320 also help to align the data to one single clock phase. In order to be able to process information from more than one bit interval for the recovery of one data bit, a memory stage 322 reuses four samples from the previous sampling period. A total of 10 samples is, therefore, fed into two half rate edge and two data detection correlation decoders 324, 326, 328, 330 that make use of a pattern recognition algorithm. Truth Table 3 represents the initial best guess for the data.

The outputs of the edge and data detector are the recovered two bits and the early and late signals going to the phase rotator control state machine 340. This involves the use of a bang-bang control circuit with adaptive step size. The state machine 342 can be viewed as a digital filter that evaluates the early and late signals and commands an adjustment of the sample point. The rotator counter 342 and temperature code generator 334 generate the 54 control signals for the phase rotator, and this closes the CDR loop.

The data path includes of a shift register 350 which loads two bits from the data correlation blocks during each half-rate cycle. The shift register is loaded to a word data register 352 (8 or 10 bits) using a word clock derived from the PLL clock. A rate counter 354 controls the shift register 350 and the 8/10 bit register 352.

The receiver also contains a pseudo-random bit stream (PRBS) generator and checker (shown within dotted lines 376) which allows for self-testing in a wrap mode as well as link testing with a corresponding transmitter. A built in self test is designed for use in receive loop-back mode. This involves a linear feedback shift register (LFSR) 372a which generates a random pattern code sequence. In this mode, the logic within the receiver core injects the generated code sequence into the first stage of the receive logic, monitors the deserialized receive data, synchronizes the receive data to the code sequence and verifies that a matching code sequence generated by a second LFSR 372b has arrived at the receiver output. The patterns are compared using an XOR 374. This serves to monitor and control the performance of the phase rotator 312. Both of the LFSRs 372a, 372b are part of the PRBS function.

The receiver circuit is of a differential type containing fixed input bias (for power savings) which translates the input signal to that compatible with a high speed differential latch. The output circuits are powered-up to support the necessary loading from the latches and wiring. The receiver phase locked loop (PLL) is the clock source for oversampling the receive data and runs at half the data rate. It typically has a given operating range from e.g. 1.0625 Gbps to 1.5625 Gbps. A frequency reference is required which is one-half the target data rate. For example, 625 Mhz is required for an operational data rate of 1.25 Gbps. Six clock phases are buffered and brought out of the PLL and are intended to drive into a phase rotator circuit.

The PLL contains a three-stage voltage controlled ring oscillator, a 2X frequency divider, phase-frequency detector, charge pump and loop filter. These elements form the "fine" control loop. The VCO has both a "fine" and "coarse" control voltage in order to minimize the required gain of the fine loop. In addition to the fine control loop elements, the PLL contains a reference generator, a voltage comparator, PLL control logic, a digital to analog converter (DAC) and a low-pass filter. These elements form the "coarse" control loop.

The fine control loop is a conventional analog loop and is intended to provide a stable low-noise low-jitter clock source for the receiver. The range, gain and bandwidth of the loop are designed to compensate for relatively high frequency but small perturbations due to power supply changes and the coarse loop.

The coarse control loop is a digital representation of a conventional analog control loop based on a 'leaky' loop filter capacitor. That type of loop relies on leakage from the loop filter cap to drive the control voltage in a particular direction regardless of the frequency of the VCO. This leakage is compensated by a phase detector and charge pump that only increase the charge on the cap. The loop is stable when the charge being added to the cap balances the charge that is leaking. The PLL control logic in the coarse control loop has an up/down counter whose value represents the charge on a loop filter cap. This counter is slowly decremented to represent leakage. The voltage comparator is high or low depending on whether the fine control voltage is operating in the upper or lower half of its range. To balance the leakage, the control logic samples the comparator output. After multiple samples showing upper range operation, the up/down counter is incremented to represent adding charge to the loop filter cap. The up/down counter output is converted to a control voltage by the DAC and low-pass filter. The coarse control loop is intended to compensate for manufacturing process and relatively low frequency but large changes due to power supply and temperature drift.

The phase rotator is an analog circuit and, as such, is a device allowing a step by step, glitch-free modulo shift of all n phases of the ring oscillator at the input to any phase angle at the output. The modulo option is guaranteeing phase and frequency compensation capability, the glitch-free performance assures that no bits are lost during rotation, and 'step by step' means that the amount of phase change is limited to one phase slice for each clock cycle.

The concept of the phase rotator is based on finite impulse response (FIR) filter principles. A ring oscillator may be seen as a circular array of delay elements. By multiplying the outputs tₙ of the array with weighting factors mₙ and summing the values, an FIR filter is built. The number of taps determine the amount of oversampling and, therefore, the order of an analog filter required for alias filtering. If the weighting factors may be changed dynamically, the FIR filter response may be changed 'on the fly'. This allows the dynamic adjustment of the output phase of such a filter.

The following illustration shows the phase rotator principle looking at one of its outputs when using a ring oscillator with six phases as a driving device. In this illustration, there are nine different weighting factors m0 to m8 available. Each of these numbers is built by summing some of the sub-factors w1 to w8. Table 1 shows the composition of m0 to m8 from the sub-factors w1 to w8. The sub-factors may be implemented in a very simple way using parallel connected transistors with width ratios w1 to w8. The summed output current of these transistors corresponds to a weighting factor mₙ. Only one sub-factor is added or subtracted at a time. An analog implementation of a summation (current summing) is not subject to any glitch. This would not be the case for an analog multiplication.

**TABLE 1**

| **Weighting factor...** | **...built from...** |
|---|---|
| m0 | =0 (not used in initial configuration) |
| m1 | = w1 |
| m2 | = w1 + w2 |
| m3 | = w1 + w2 + w3 |
| m4 | = w1 + w2 + w3 + w4 |
| m5 | = w1 + w2 + w3 + w4 + w5 |
| m6 | = w1 + w2 + w3 + w4 + w5 +w6 |
| m7 | = w1 + w2 + w3 + w4 + w5 +w6 + w7 |
| m8 | = w1 + w2 + w3 + w4 + w5 +w6 + w7 + w8 |

The stepwise change of the output phase occurs by sequentially changing the weighting factors that determine the contribution from each phase tap to the actual output. For a 'clever' setting of the weight values w1 to w8, this will shift the output phase by exactly one-ninth of a phase slice. After the last rotating step, all weights have been shifted by one tap position. This corresponds to a shift of one phase slice at the output of the FIR.

By repetition of the above sequence, any phase setting may be tuned in. Because this is a circular operation, the range of the output phase is not limited to the 0 to 360 degree interval. This allows a continuous variation of the phase and thereby a frequency adjustment. Due to the fact that the weighting factors are only changed by adding or subtracting one sub-factor element at a time, no glitches can occur.

Each FIR coefficient c1 to c6 is controlled by a temperature code that determines whether a sub-factor is 'on' or 'off'. The temperature codes controlling the sub-factors for one phase step of a six-phase oscillator are given in Table 2. It may be seen that after nine steps, the codes are modulo shifted to the right by one coefficient position and, therefore, by one oscillator phase. The basic phase granularity of the oscillator (360 degrees divided by the number of oscillator phases) is divided by a factor of nine in this case. This is a big advantage because it will result in a lower static phase error.

**TABLE 2**

| **Temperature codes controlling which sub-factors are summed to form the actual coefficients c0 to c5 (two phase shifts)** | | | | | | |
|---|---|---|---|---|---|---|
| **Step** | **c0** | **c1** | **c2** | **c3** | **c4** | **c5** |
| 0 | 000 000 111 | 000 111 111 | 111 111 111 | 111 111 111 | 000 111 111 | 000 000 111 |
| 1 | 000 000 011 | 000 111 111 | 111 111 111 | 111 111 111 | 000 111 111 | 000 001 111 |
| 2 | 000 000 001 | 000 111 111 | 111 111 111 | 111 111 111 | 000 111 111 | 000 011 111 |
| 3 | 000 000 000 | 000 111 111 | 111 111 111 | 111 111 111 | 000 111 111 | 000 111 111 |
| 4 | 000 000 000 | 000 111 111 | 011 111 111 | 111 111 111 | 001 111 111 | 000 111 111 |
| 5 | 000 000 000 | 000 111 111 | 001 111 111 | 111 111 111 | 011 111 111 | 000 111 111 |
| 6 | 000 000 000 | 000 111 111 | 000 111 111 | 111 111 111 | 111 111 111 | 000 111 111 |
| 7 | 000 000 001 | 000 011 111 | 000 111 111 | 111 111 111 | 111 111 111 | 000 111 111 |
| 8 | 000 000 011 | 000 001 111 | 000 111 111 | 111 111 111 | 111 111 111 | 000 111 111 |
| 9 | 000 000 111 | 000 000 111 | 000 111 111 | 111 111 111 | 111 111 111 | 000 111 111 |
| 10 | 000 001 111 | 000 000 011 | 000 111 111 | 111 111 111 | 111 111 111 | 000 111 111 |
| 11 | 000 011 111 | 000 000 001 | 000 111 111 | 111 111 111 | 111 111 111 | 000 111 111 |
| 12 | 000 111 111 | 000 000 000 | 000 111 111 | 111 111 111 | 111 111 111 | 000 111 111 |
| 13 | 000 111 111 | 000 000 000 | 000 111 111 | 011 111 111 | 111 111 111 | 001 111 111 |
| 14 | 000 111 111 | 000 000 000 | 000 111 111 | 001 111 111 | 111 111 111 | 011 111 111 |
| 15 | 000 111 111 | 000 000 000 | 000 111 111 | 000 111 111 | 111 111 111 | 111 111 111 |
| 16 | 000 111 111 | 000 000 001 | 000 011 111 | 000 111 111 | 111 111 111 | 111 111 111 |
| 17 | 000 111 111 | 000 000 011 | 000 001 111 | 000 111 111 | 111 111 111 | 111 111 111 |
| 18 | 000 111 111 | 000 000 111 | 000 000 111 | 000 111 111 | 111 111 111 | 111 111 111 |

It is understood that this table shows 18 steps for two phases of the oscillator whereas a total of 54 steps is required for all six phases. The code for the remaining 36 steps can readily be determined from the pattern of the 18 steps shown on the table.

The receive phase buffers consist of circuits which are designed to interface to the output drive sections (all phases) of the phase rotator circuit, while subjecting the phase rotator to only light loading. The phase buffers then drive from the phase rotator to a set of latches while providing the required input drive necessary for the phase rotator circuit. The receive phase buffers operate at a rate necessary for a half rate design. The phase buffers also provide adequate rise and fall times taking into account the estimated net loadings.

The sample latches are fed data by the input receiver circuit, and obtain clocks from the combination of the PLL, phase rotator circuit, phase buffer complex. The data input to the sample latches is differential in nature and, as such, the sample latches are pseudo analog circuits. The design of the input receiver and the sample latches are very closely coordinated to minimize the effects of noise on the jitter associated with these two circuits. Typically, the sample latch is a CMOS positive edge triggered latch.

The method for the phase rotator control is an advanced bang-bang state machine with eight-fold initial early/late averaging, such as that shown in Figure 3. It has 16 states and may be implemented using four latches. The state machine 340 has two inputs, one for early and one for late. The early and late signals are a function of the input sample pattern. They are generated by use of an edge and data correlation table of the type shown in Table 3.

**TABLE 3**

| **Full Rate Patterns for Early and Late Signals** | | | |
|---|---|---|---|
| **pattern EL** | **pattern EL** | **pattern EL** | **pattern EL** |
| 0000000 00 G | 1111111 00 G | 0100101 00 - | 1011010 00 - |
| 0000001 01 * | 1111110 01 * | 1010010 00 - | 0101101 00 - |
| 1000000 10 * | 0111111 10 * | 0110010 00 - | 1001101 00 - |
| 0000010 00 - | 1111101 00 - | 0100110 00 - | 1011001 00 - |
| 0100000 00 - | 1011111 00 - | 0100111 00 - | 1011000 00 - |
| 0000011 00 G | 1111100 00 G | 1110010 00 - | 0001101 00 - |
| 1100000 00 G | 0011111 00 G | 0101001 00 - | 1010110 00 - |
| 0000100 00 - | 1111011 00 - | 1001010 00 - | 0110101 00 - |
| 0010000 00 - | 1101111 00 - | 0101010 00 - | 1010101 00 - |
| 0000101 00 - | 1111010 00 - | 0101011 00 - | 1010100 00 - |
| 1010000 00 - | 0101111 00 - | 1101010 00 - | 0010101 00 - |
| 0000110 10 ? | 1111001 10 ? | 0110001 01 - | 1001110 01 ? |
| 0110000 01 ? | 1001111 01 ? | 1000110 10 - | 0111001 10 ? |
| 0000111 10 * | 1111000 10 * | 0110011 00 - | 1001100 00 - |
| 1110000 01 * | 0001111 01 * | 1100110 00 - | 0011001 00 - |
| 0001001 00 - | 1110110 00 - | 1000001 00 - | 0111110 00 - |
| 1001000 00 - | 0110111 00 - | 1000011 00 G | 0111100 00 G |
| 0001010 00 - | 1110101 00 - | 1100001 00 G | 0011110 00 G |
| 0101000 00 - | 1010111 00 - | 1000101 00 - | 0111010 00 - |
| 0001011 00 - | 1110100 00 - | 1010001 00 - | 0101110 00 - |
| 1101000 00 - | 0010111 00 - | 1000111 10 * | 0111000 10 * |
| 0010001 00 - | 1101110 00 - | 1110001 01 * | 0001110 01 * |
| 1000100 00 - | 0111011 00 - | 1001001 00 - | 0110110 00 - |
| 0010010 00 - | 1101101 00 - | 1001011 00 - | 0110100 00 - |
| 0100100 00 - | 1011011 00 - | 1101001 00 - | 0010110 00 - |
| 0010011 00 - | 1101100 00 - | 1010011 00 - | 0101100 00 - |
| 1100100 00 - | 0011011 00 - | 1100101 00 - | 0011010 00 - |
| 0100001 00 - | 1011110 00 - | 1100011 00 G | 0011100 00 G |
| 1000010 00 - | 0111101 00 - | 1100111 10 ? | 0011000 10 ? |
| 0100010 00 G | 1011101 00 G | 1110011 01 ? | 0001100 01 ? |
| 0100011 00 G | 1011100 00 G | 1101011 00 - | 0010100 00 - |
| 1100010 00 G | 0011101 00 G | 1110111 00 - | 0001000 00 - |

| | | | |
|---|---|---|---|
| G = Good No Change * = Clear Need to Move ? = Probable Need to Move - = Not Enough Information | | | |

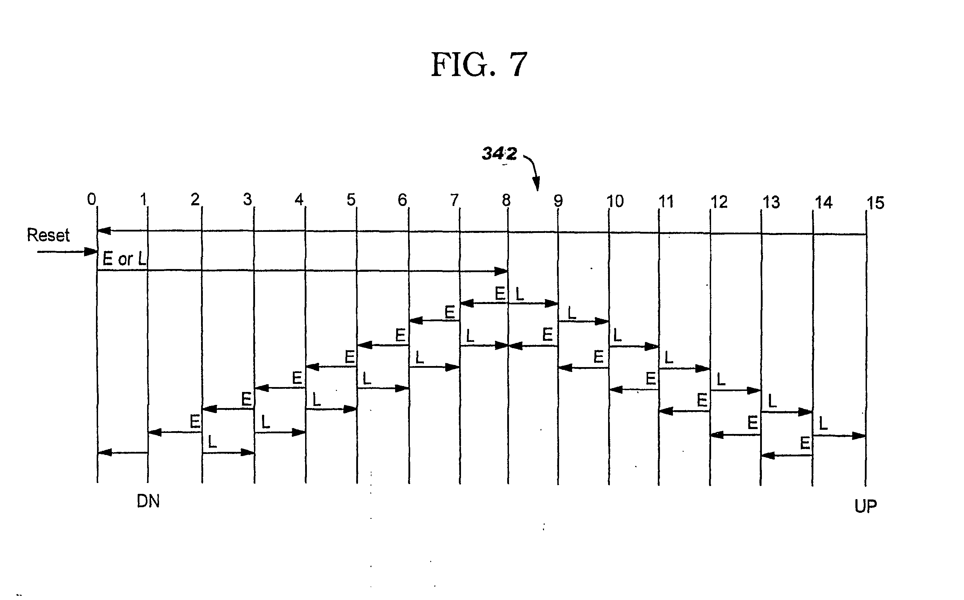

The method for the phase rotator control is an advanced bang-bang state machine. As seen at 342 in Figure 7 it involves eight-fold initial early/late averaging. It has sixteen states and may be implemented using four latches. Referring again to Figure 6, the state machine 342 has two inputs, one for early and one for late. The averaging effect is achieved in the following manner. The state machine 342 is set to 8. If several early signals in a row, but not enough to drive the state to '1', are followed by several late signals, the state machine averages them out. However, when a preponderance of early or late signals takes the state machine to '1' or '14', the state machine determines that the sampling is occurring too early or too late and determines whether to change the sample point. The state machine produces a 'late' signal when it gets to a state '1', and an 'early' signal when it gets to a state '14'. This output signal from the state machine, if it is a 'late' signal, instructs the rotation counter to adjust the sampling to a later point. Conversely, an 'early' signal will instruct the counter to adjust the sampling to an earlier point.

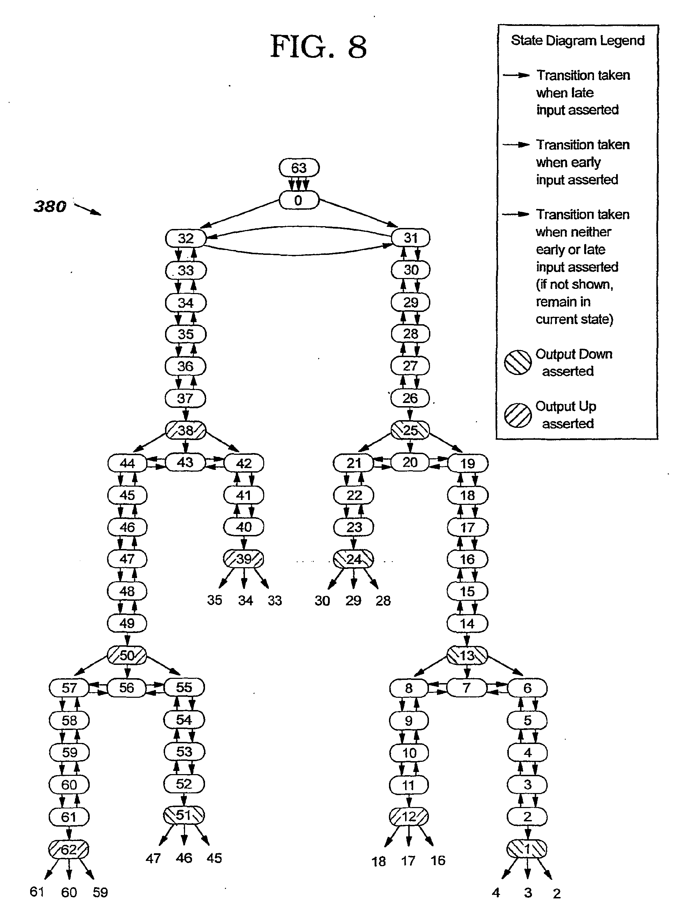

Figure 8 shows the operation of a second embodiment of the state machine. This machine 380 combines early/late averaging with adaptive behavior that changes the amount of averaging based on the number of consecutive early or late inputs. When a sustained sequence of early or late inputs is received, this state machine reduces the amount of averaging in order to increase the stepping rate for the phase rotator. This state machine contains 64 states and requires six latches. As with the prior embodiment, the state machine is followed by an 'up and down' counter with 54 steps requiring six flip-flops. The counter has 54 steps, and controls where the sample point will be. The counter processes two bits at a time in parallel. Thus, there are 27 positions where the sample point can be set for each bit. That defines the limits of the resolution. As noted, the state machine determines whether to change the sample point and the counter determines where the new sample point will be.

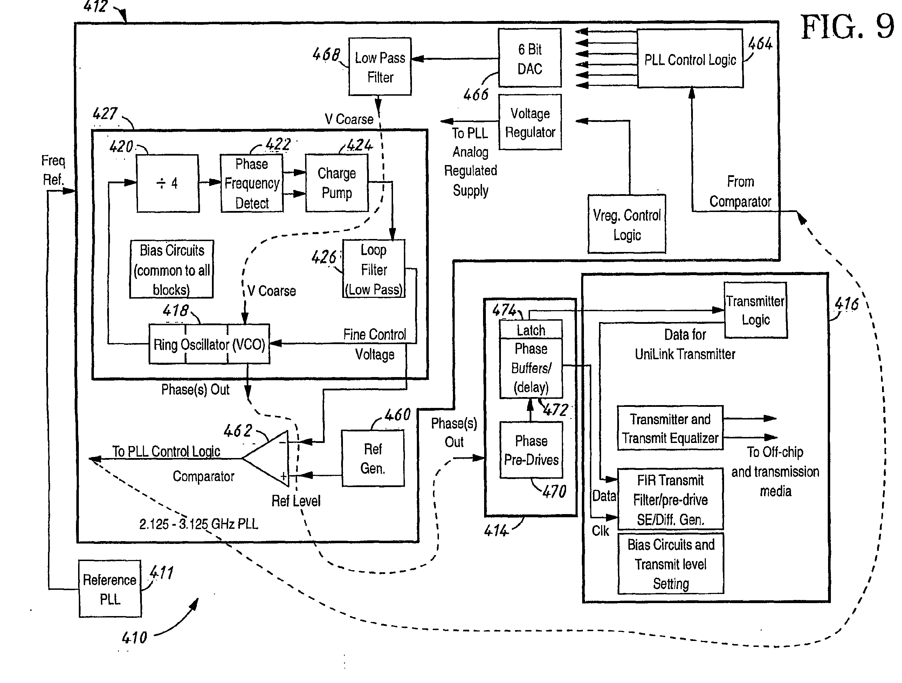

Referring now to Figure 9, a block diagram of a transmitter analog architecture 410 is shown. The transmitter architecture 410 is supported by three major analog blocks: a full data rate phase locked loop (PLL) 412, a Phase Buffer circuit 414 to repower the PLL signal, and an off-chip Finite Impulse Response (FIR) equalization driver circuit 416. Within the PLL 412 are a "fine" control loop circuit 427 and a "coarse" control loop.

The transmitter PLL 412 is the clock source for the transmitted data and preferably runs at the full data rate. At full rate, less duty cycle distortion and jitter occur, and the present embodiment of the invention is able to run at full rate efficiently. A frequency reference is 1/nth target data rate. For example for n=4, 625 Mhz is required for an operational data rate of 2.5 Gbps. A single clock phase is buffered and brought out of the PLL 412 and is intended to drive into the Phase Buffer circuit 414.

The PLL 412 illustrated contains a multi-stage, voltage controlled ring oscillator (VCO) 418, a frequency divider 420, phase-frequency detector 422, charge pump 424 and multi-pole "ripple capacitor" loop filter 426. These elements form a "fine" control loop 427. Although, in the embodiment described herein, the VCO 418 is a four-stage oscillator and the frequency divider 420 is a four-times divider, other stage and divider multiples will be apparent to one skilled in the art, and the loop is not limited to the specific four-stage oscillator and four-times divider elements described. The fine control loop 427 is a conventional analog loop and is intended to provide a stable low-noise low-jitter clock source for the transmitter circuit 410. The range, gain and bandwidth of the loop 427 is designed to compensate for relatively high frequency but small perturbations due to power supply changes and the coarse loop.

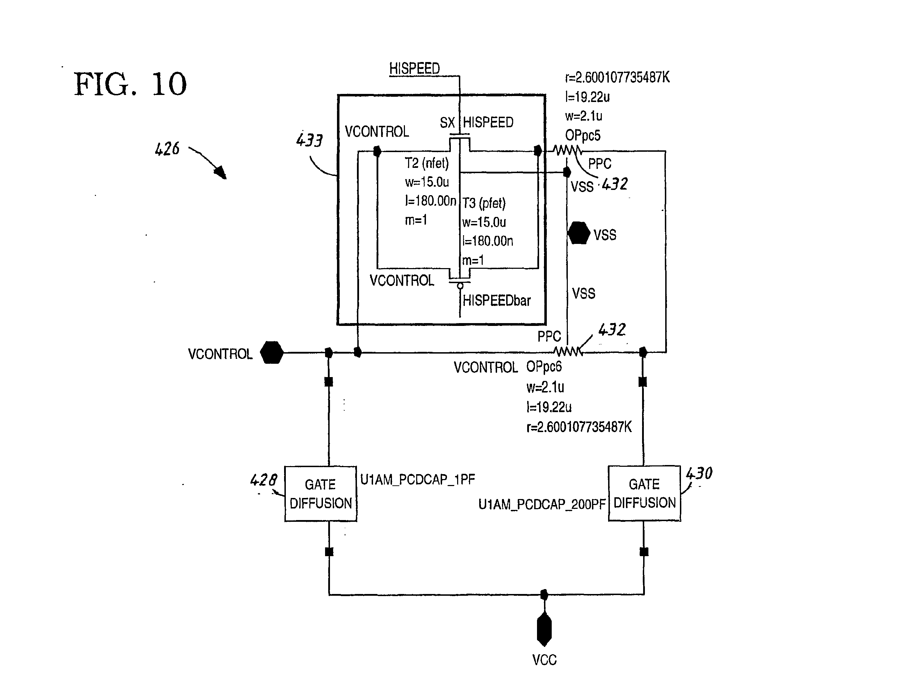

Referring now to Figure 10, a schematic of one embodiment of the loop filter 426 is provided. The loop filter circuit 426 illustrated is a second order CRC low pass filter. A small "ripple" capacitor 428 is used to attenuate charge pump ripple, and a larger "loop filter" capacitor 430 is used to stabilize the circuit and set the dominant pole. The loop filter circuit 426 converts the charge pump current received from the charge pump 424 into a control voltage that drives the VCO circuit 418. Resistors 432 add a zero into the circuit to null out the affect of the pole at the origin (caused by the VCO 418). The loop filter circuit 426 also sets the dominant pole of the circuit. The ripple capacitor 428 is much smaller than the loop filter capacitor 430. This keeps its pole much further out in the frequency. The resistors 432 also factor into the open loop gain which comes into play for the stability of the system and the settling time (or response time of the circuit). Although, in the embodiment illustrated, the VCO circuit 418 gain ranges from 300MHz to 3.8GHz depending upon process and temperature, other gain values may be achieved, as will be readily apparent to one skilled in the art. Accordingly, the resistors 432 are switchable. A switch 433 is controlled by logic based on the operation of the PLL circuit 412, said logic preferably setting a range between 2.5GHz and 3.125GHz in the current embodiment. Other embodiments (not shown) may have a value range greater or smaller, or covering a different value range; the range described is for illustrative purposes only. The VCO 418 has both a "fine" and "coarse" control voltage in order to minimize the required gain of the fine loop 427.

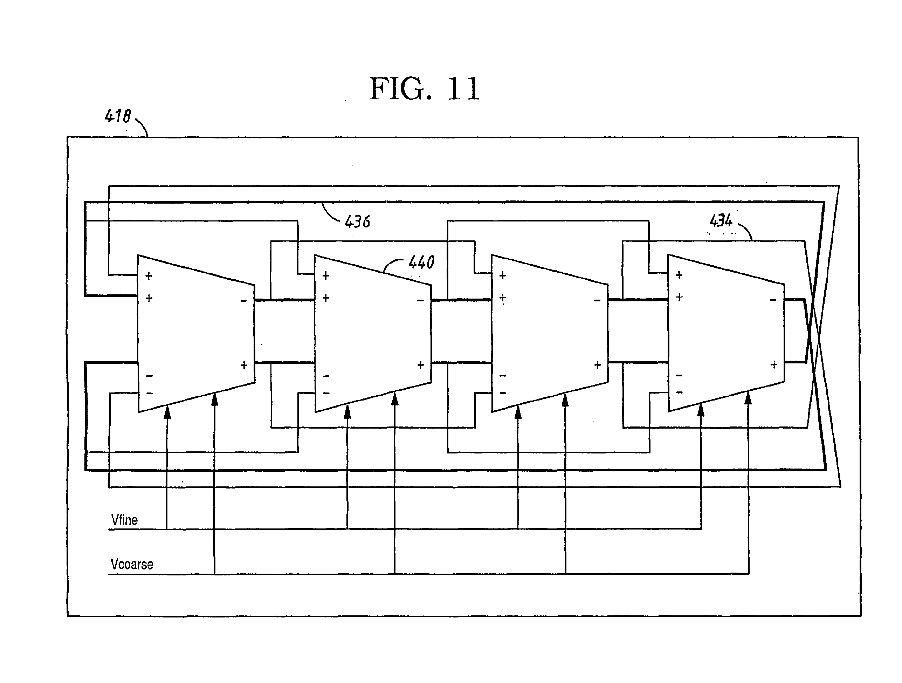

Referring now to Figure 11, a schematic of a four-stage delay cell embodiment of the transmitter VCO 418 is provided. The VCO 418 itself is of a form which adjusts the speed of oscillation by adjusting local feedback within a plurality of delay cells 440, as well as controlling feedback within the VCO 418, which provides pre-charge of the delay cells 440 for speed enhancement. It is preferred that the VCO operate at 2.125GHz to 3.125GHz across a defined range of operating conditions and produce a differential clock output. Other embodiments (not shown) may have a value range greater or smaller, or covering a different value range; the range described is for illustrative purposes.

In a conventional ring oscillator, the oscillation frequency is determined as 1/(2Nô), where N is the number of stages and ô is the unit delay time of a delay cell. Hence, the frequency of oscillation is decided by the delay time of one delay element. Higher operation frequency and wider tuning range are achieved in the embodiment invention illustrated in Figure 11 by implementing a dual delay scheme. Dual-delay means that both negative skewed delay paths 434 and normal delay paths 436 exist in the same oscillator. (In Figure 11 the negative skewed delay paths 434 are represented by normal lines, and the normal delay paths 436 as thicker boldface lines.) The negative skewed delay paths 434 decrease the unit delay time below that of a single inverter delay time. As a result, a higher operating frequency can be obtained. Since the normal delay paths 436 also exist, the frequency range of the VCO 418 can be wider than that of an oscillator with only skewed delay paths.

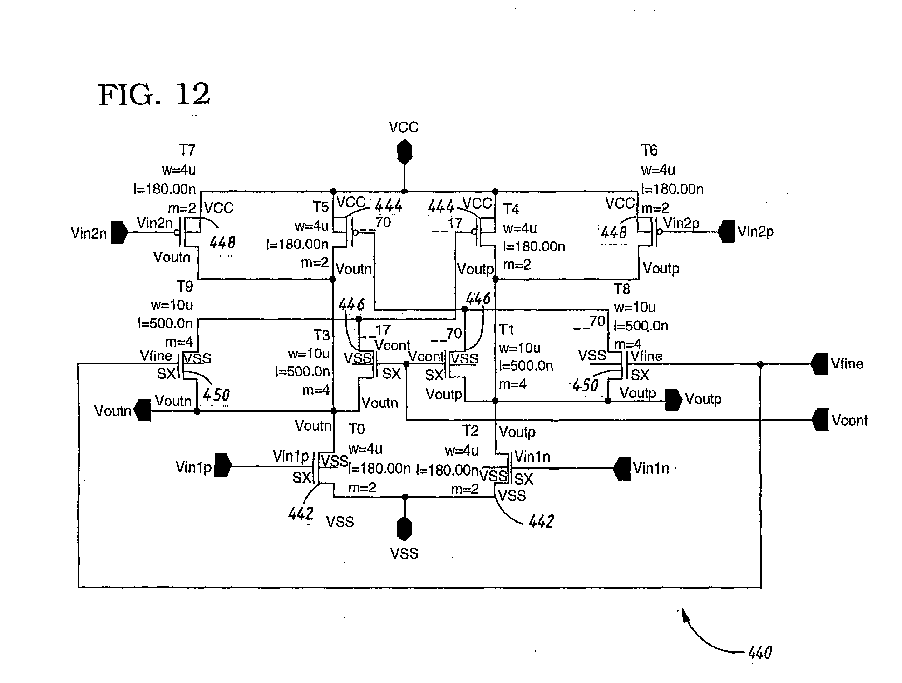

Referring now to Figure 12, a schematic of a VCO 418 transmit delay cell 440 is provided. It is preferred that the delay cell 440 be tunable from 80 ps to 125 ps delay over the VCO 418 operating range. Other embodiments (not shown) may have a value range greater or smaller, or covering a different value range; the range described is for illustrative purposes only. It is also preferred that the delay cell 440 produce full swing differential outputs. At the core of the delay cell 440 is an NMOS differential pair (T0,T2) 442 with a PMOS pair latch (T4,T5) 444 as an active load. Cross-coupled NMOS transistors (T1,T3) 446 control the maximum gate voltage of a pair of PMOS load transistors 448 and limit the strength of the PMOS latch 444. When the control voltage is low, the strength of the latch 444 becomes weak, and the output driving current of the PMOS latch 444 load increases. Therefore, the state of the latch 444 is changed easily and the delay time is reduced. Thus, when the control voltage is high, the latch 444 becomes strong, and it resists the voltage switching in the differential delay cell 440. As a result, the delay time increases. With the help of the positive feedback of the latch 444, the transition edges of the output waveform remain sharp in spite of slow delay time. Since the delay cell 440 is basically a simple differential inverter, a full-swing waveform is generated.

To utilize both negative skewed and normal delay paths, the pair of PMOS transistors (T6, T7) 448 are added to the PMOS loads of the delay cell 440 and are used to take the negative skewed signals. The negative skewed signal is connected to the PMOS input of the delay cell 440 and the normal signal is connected to the NMOS input of the delay cell. The negative skewed signal is taken from the two stages before the current delay stage. The signal prematurely turns on the PMOS during the output transition and compensates for the performance of the PMOS, which is usually slower than that of the NMOS.

A second pair of NMOS transistors (T8,T9) 450 is inserted in shunt with the original NMOS cross coupled pair 446. These devices are smaller and longer and, therefore, have less effect on performance. This allows for a "fine" control of the delay cell.

Referring again to Figure 9, in addition to the fine control loop 427 elements, the PLL 412 contains a reference generator 460, a voltage comparator 462, PLL control logic 464, a Digital to Analog Converter (DAC) 466 and a low-pass filter 468. These elements form the digital "coarse" control loop. This digital coarse loop is used to compensate for process and temperature to put the VCO 418 in the correct operating range. Although the embodiment of the PLL 412 described thus far is a dual loop PLL having both "fine" and "coarse" loops, alternative embodiments may utilize only one loop, and a dual loop PLL structure is not required for this structure. The analog fine loop 427 is then able to lock to the reference clock and produce a preferred stable 2.125GHz/3.125GHz clock. Other embodiments (not shown) may have different clock values, and the values described are for illustrative purposes only. It is preferred that the reference level for the comparator 462 is produced by a cbias circuit 411.

The coarse control loop is a digital representation of a conventional analog control loop based on a "leaky" loop filter capacitor. That type of loop relies on leakage from the loop filter circuit 426 to drive the control, voltage in a particular direction regardless of the frequency of the VCO 418. This leakage is compensated by the phase detector 422 and charge pump 424, which only increase the charge on the loop filter circuit 426. The loop is stable when the charge added to the loop filter circuit 426 balances the charge that is leaking.

The PLL control logic 464 in the coarse control loop has an up/down counter (not shown) whose value represents the charge on the loop filter circuit 426. This counter is slowly decremented to represent leakage. The voltage comparator 462 is high or low depending on whether the fine control voltage is operating in the upper or lower half of its range. To balance the leakage, the control logic 464 samples the comparator 462 output. After multiple samples showing upper range operation, the up/down counter (not shown) is incremented to represent adding charge to the loop filter circuit 426. The up/down counter (not shown) output is converted to a control voltage by the DAC 466 and low-pass filter 468. The coarse control loop is intended to compensate for manufacturing process and relatively low frequency but large changes due to power supply and temperature drift. It is discussed more thoroughly in relation to Figures 4 to 8.

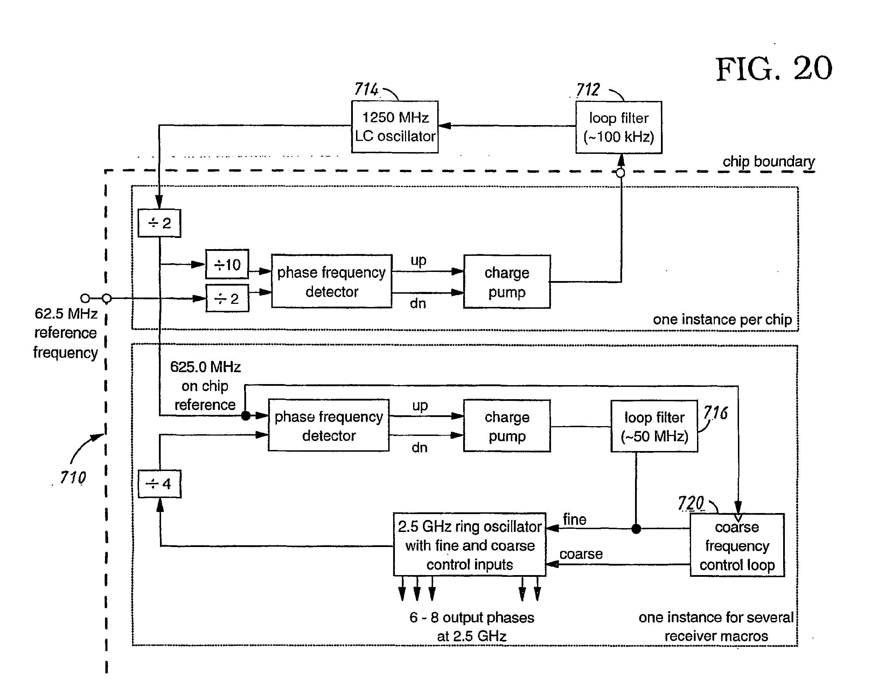

Figure 20 is block diagram of another embodiment of a dual loop PLL. From PLL theory, it is known that for good phase noise/jitter performance, the tuning sensitivity and the multiplication factor should be small. As a potential solution to these problems, a two-stage reference frequency multiplication is suggested with an external loop filter 712 and LC oscillator 714 in the first stage and a dual loop on-chip PLL 710 in the second stage. The first loop filter 716 has a narrow bandwidth, eventually allowing to meet jitter transfer requirements. The phase noise/jitter performance should be dominated by the quality of the external VCO and may by specified or selected by the customer. The second PLL loop filter (not shown) is as large as possible to suppress any ring oscillator noise. This is intended to allow a tracking of the performance of the 625 MHz signal from the first loop, dominating the overall jitter performance.

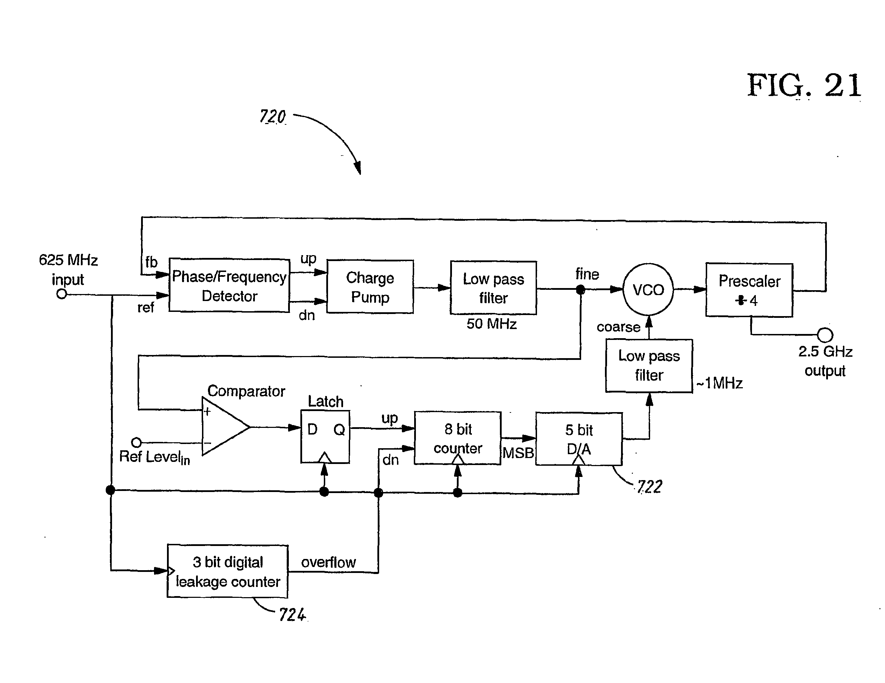

Figure 21 is a block diagram of the coarse frequency control loop 720 of Figure 20. The basic idea is to introduce a controlled amount of digital leakage into one frequency direction. The voltage of the fine tune input is sampled and, if a predefined level is crossed, the coarse voltage is digitally adjusted with a D/A converter 722. With this approach, the loop gain in one direction is essentially zero. This breaks the loop and guarantees stability. A digital integrator (counter) 724 realizes a low pass function for improved switching noise.

Referring again to Figure 9, a Phase Buffer circuit 414 comprises phase pre-drive circuits 470, phase buffer/delay circuits 472 and a transmit phase buffer latch 474. The phase buffers 472 drive out to the latch 474 and thereby provides the clock necessary for the full rate design of the present embodiment. The phase buffers 472 must also provide adequate rise and fall times taking into account the estimated net loading.

The phase buffers 472 may comprise any circuits that drive clocks from sources to circuits that have high capacitive loading due to wiring and/or gate loading. At the clock rates used in the present invention, phase buffers 472 are important in assuring reasonable rise and fall times, duty cycle, and jitter performance of system clocks. The phase buffers 472 are described in more detail later in this specification in the description of the receiver PLL circuitry.

One embodiment of an equalization driver circuit 416 is illustrated in Figure 9. The equalization driver circuit 416 is a Finite Impulse Response (FIR) equalization driver comprising current-mode differential drive circuits that are controlled by a FIR-type filter function. It is preferred to equalize the transmitter data stream as a means of minimizing the amount of inter-symbol interference created by copper skin effect and circuit card dissipation factor; the former related to the root of the operating frequency, the latter related in a linear manner to the operating frequency. The transmitter FIR circuit 416 is described in detail in the related U.S. patent application entitled "Programmable Driver/Equalizer with Alterable Analog Finite Impulse Response (FIR) Filter Having Low Intersymbol Interference & Constant Peak Amplitude Independent of Coefficient Settings" (Docket No. RAL920000097US1), Serial No. 09/749908, filed December 29, 2000. Other types of equalization driver circuits may be used and the driver circuit described is for illustrative purposes only.

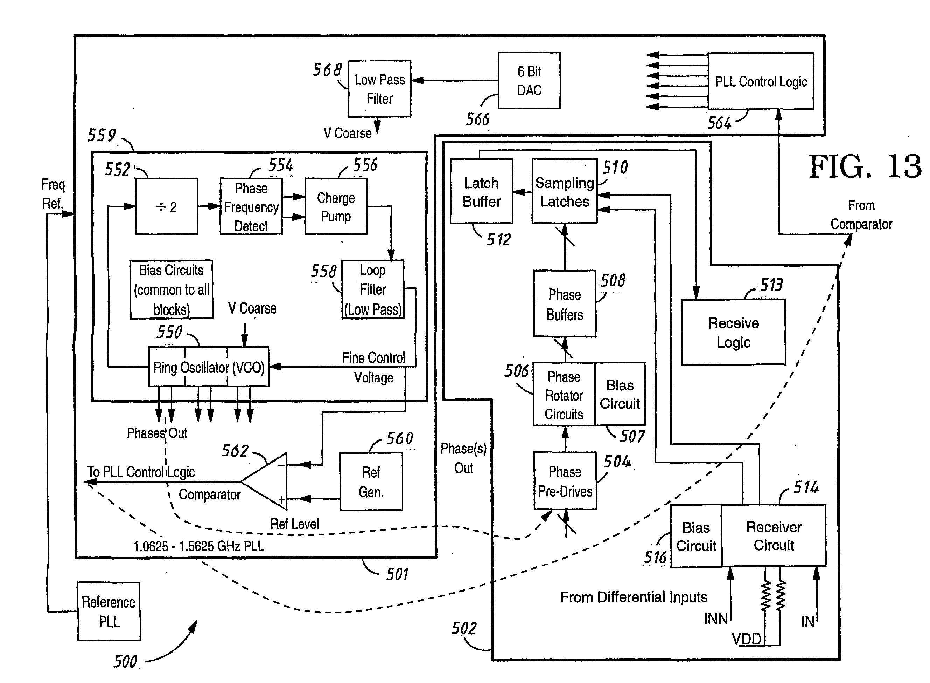

Referring now to Figure 13, a block diagram of receiver analog architecture 500 is shown, comprising a half-data rate PLL circuit 501 and an analog receiver circuit block 502. The analog receiver circuit block 502 comprises a Phase Pre-Drive 504, Phase Rotator Circuits 506 and associated phase rotator bias circuits 507, a Phase Buffer circuit 508 to repower the PLL signals, six sampling latches 510, and latch buffer 512 driving receiver logic 513. Providing six latches allows the circuit to have three samples per bit of data for a half-data rate. The sampling latches 510 are also interfaced with a receiver circuit 514 that is a differential type containing fixed input bias 516 (for power savings) which translates the input signal to that compatible with a high speed differential latch. The output circuits are powered-up to support the necessary loading from the latches and wiring.

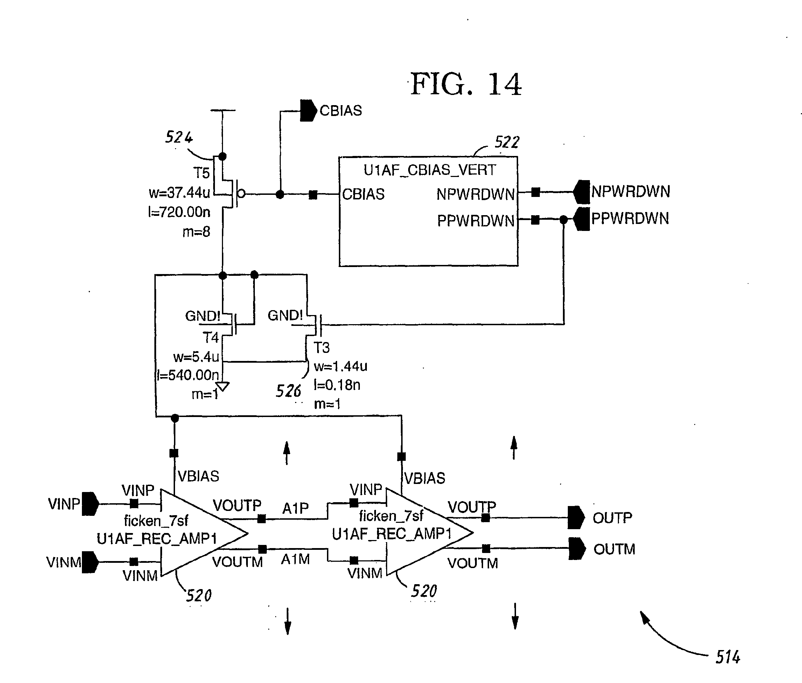

An embodiment of the receiver circuit 514 is illustrated in Figure 14. It is designed to supply a required differential output voltage to six sample latches from an input differential voltage bitstream operating at 2.5Gb/s. The preferred requirements for the receiver circuit 514 are noted in Table 4 below. The measured results were taken at the operating condition that yielded the worst performance with 150mVP-P additional noise on VDD. All results are on a per-link basis for the fully extracted receiver. It is to be understood that other embodiments (not shown) may have different requirements, and the values described are for illustrative purposes only.

**Table 4: Receiver Circuit Specifications**

| **Specification** | **Requirement** | **Measured** | **Operating Cond.** |
|---|---|---|---|
| Maximum Current | 6mA | 6.6mA | 1.98V, 25°C, ASICBC |
| Jitter from Power Supply Noise and Process Limitations | 13ps | 24.6ps | 1.62V, 125°C, ASICWC |
| Minimum Differential P-P Input | 100mV | 100mV | 1.62V, 125°C, ASICWC |
| Minimum Differential P-P Output | 800mV | 858mV | 1.62V, 125°C, ASICWC |
| Output Common Mode | 0.9V-1.3V | 0.95V-1.2V | all conditions |
| Bandwidth | not specified | 918MHz | 1.62V, 125°C, ASICWC |
| DC Gain | not specified | 10.5 | 1.62V, 125°C, ASICWC |
| Input Common Mode Range | not specified | 0.6V-1.6V | 1.62V, 125°C, ASICWC |

Receiver circuit 514 is comprised of a bias network and two differential amplifiers 520. A CBIAS cell 522 provides a DC reference voltage for a PMOS transistor 524 that is then converted to a reference voltage for an NMOS transistor 526. Two stages of amplification were chosen to try to maximize gain and bandwidth; however, the invention is not limited to two stages.

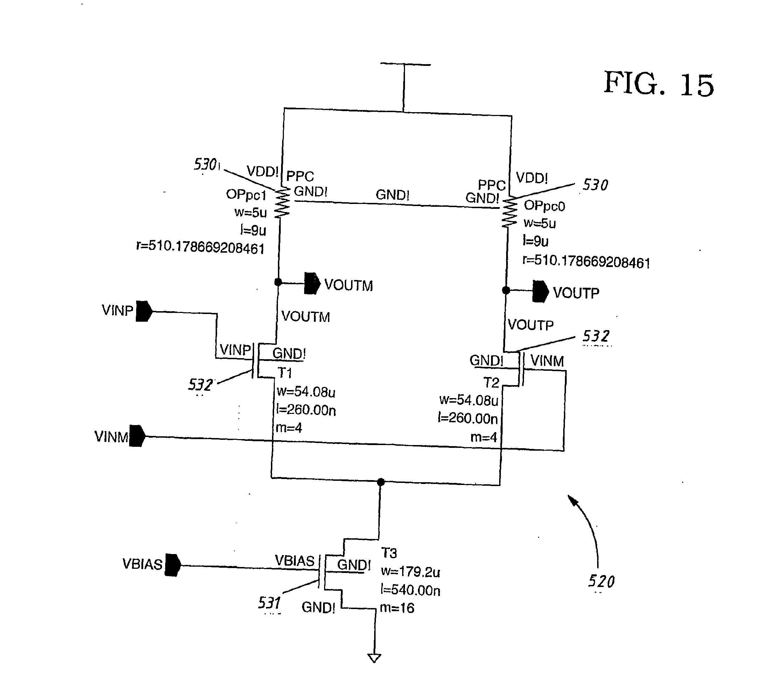

Figure 15 is a schematic view of the differential amplifier 520 of Figure 14. It is a traditional design with an NMOS tail current and resistive loading to give the necessary bandwidth. The NMOS tail 531 mirrors off the 100µA CBIAS current to provide approximately 3mA to the diff-pair 532. This 3mA is based on the maximum allowable current for the receiver. The size of the resistors 530 was chosen to provide the necessary output common mode voltage based on the 1.5mA pulled through each. The input transistors 532 were then sized to achieve a gain of approximately 20dB.

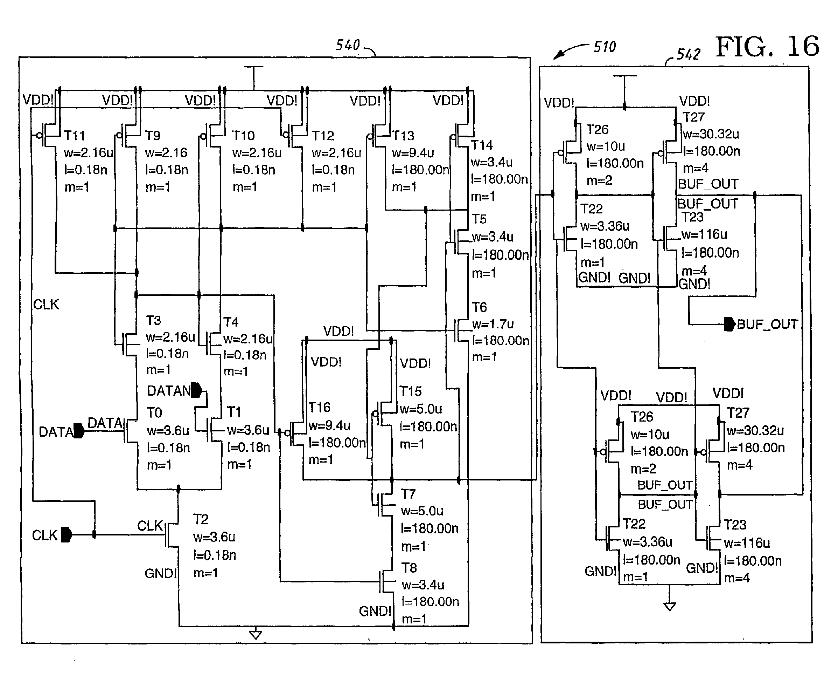

Figure 16 is a schematic diagram of an exemplary sampling latch 510 referred to by Figure 13. The sample latches 510 are fed data by the input receiver circuit 514 and obtain clocks from the combination of the PLL circuit 501, phase rotator circuit 506 and phase buffer complex 50B. The data input to the sample latches 510 is differential in nature and, as such, the sample latches 510 are pseudo analog circuits. It is important that the design of the input receiver and the sample latches be very closely coordinated to minimize the effects of noise on the jitter associated with these two circuits.

The latch 510 illustrated in Figure 16 is a CMOS, positive edge triggered latch circuit. It takes differential data inputs and single ended clock and outputs a single ended, logic level signal. The complex consists of two circuits, the latch 540 itself and a buffer 542 that sharpens the output of the latch 540. The latch 540 receives its differential data from the receiver circuits 514 and performs differential or single ended conversion to it and drives the output to the receive logic 513.

With CLK-Q delay <300ps (nominal) and a sample and hold window <35ps as performance boundaries, an embodiment of the latch circuit 510 illustrated in Figure 16 was simulated over various process, temperature and supply conditions with varying loads. The appropriate parameters were measured to ensure adequate performance over these conditions. Also, siz=laticno were performed to determine the setup and hold window, the meta-stability window, and the jitter performance of the latch 510. The following Table 5 demonstrates various performance parameters of the latch circuit 510.

**Table 5: Latch Operating Parameters**

| **Operating Conditions** | **CLK-Q delay ps** | **tr ps** | **tf ps** |
|---|---|---|---|
| TT.T=50, VDD=1.8, Load=30fF, Nominal CLK | 187 | 37 | 34 |
| ASICWC, T=125C, VDD=1.62, Load=40fF, Slow CLK | 297 | 56 | 52 |
| ASICBC, T-25C, VDD=1.98, Load-20fF, Fast CLK | 129 | 29 | 26 |

The sampling latch circuit 510 has a negative setup and hold window. It was measured with respect to the output of the latches 510 (and not with respect to the output of the latch buffer 512). Any CLK-data delay that result in more than 300ps CLK-Q delay was also included in this window calculation. The preferred sample and hold window for this latch is 10ps.

Referring again to Figure 13, the receiver PLL circuit 501 is the clock source for oversampling the receive data and runs at half the data rate. A frequency reference is required which is 1/nth target data rate; for example, for n=2, 625 Mhz is required for an operational data rate of 1.25 Gbps. Six clock phases are buffered and brought out of the PLL and are intended to drive into the Phase Rotator circuit 506.

The receive PLL 501 of Figure 13 has a six-stage voltage controlled ring oscillator (VCO) 550, a 2X frequency divider 552, phase-frequency detector 554, charge pump 556 and multi-pole loop filter 558. These elements form the "fine" control loop. The receive VCO 550 has both a "fine" and "coarse" control voltage in order to minimize the required gain of the fine loop. In addition to the fine control loop elements, the receive PLL 501 contains a reference generator 560, a voltage comparator 562, PLL control logic 564, a Digital to Analog Converter (DAC) 566 and a low-pass filter 568. These elements form the "coarse" control loop.

The fine control loop 559 is a conventional analog loop and is intended to provide a stable low-noise low-jitter clock source for the receiver. The range, gain and bandwidth of the loop is designed to compensate for relatively high frequency but small perturbations due to power supply changes and the coarse loop.

The coarse control loop is a digital representation of a conventional analog control loop based on a "leaky" loop filter capacitor. That type of loop relies on leakage from the "loop filter cap" to drive the control voltage in a particular direction regardless of the frequency of the receive VCO 550. This leakage is compensated by the phase detector 554 and charge pump 556 that only increase the charge on the "cap." The loop is stable when the charge being added to the cap balances the charge that is leaking.

The receive PLL control logic 564 in the coarse control loop has an up/down counter (not shown) whose value represents the charge on a loop filter cap. This counter is slowly decremented to represent leakage. The voltage comparator 562 is high or low depending on whether the fine control voltage is operating in the upper or lower half of its range. To balance the leakage, the receive PLL control logic 564 samples the comparator 562 output. After multiple samples showing upper range operation, the up/down counter is incremented to represent adding charge to the loop filter cap. The up/down counter output is converted to a control voltage by the DAC 566 and low-pass filter 568. The coarse control loop is intended to compensate for manufacturing process and relatively low frequency but large changes due to power supply and temperature drift.

It is preferred that the receive PLL 501 operate from about 1GHz to about 1.6GHz across a range of operating conditions, and that it produce six evenly spaced phases. The digital coarse loop is used to compensate for process and temperature to put the receive VCO 550 in the desired operating range. The lower bandwidth analog fine loop is then able to lock to the reference clock and produce six stable 1.0GHz to 1.6GHz phases. Other embodiments (not shown) may have a value range greater or smaller, or covering a different value range; the range described is for illustrative purposes only The reference level for the comparator 562 is produced by cbias (not shown).

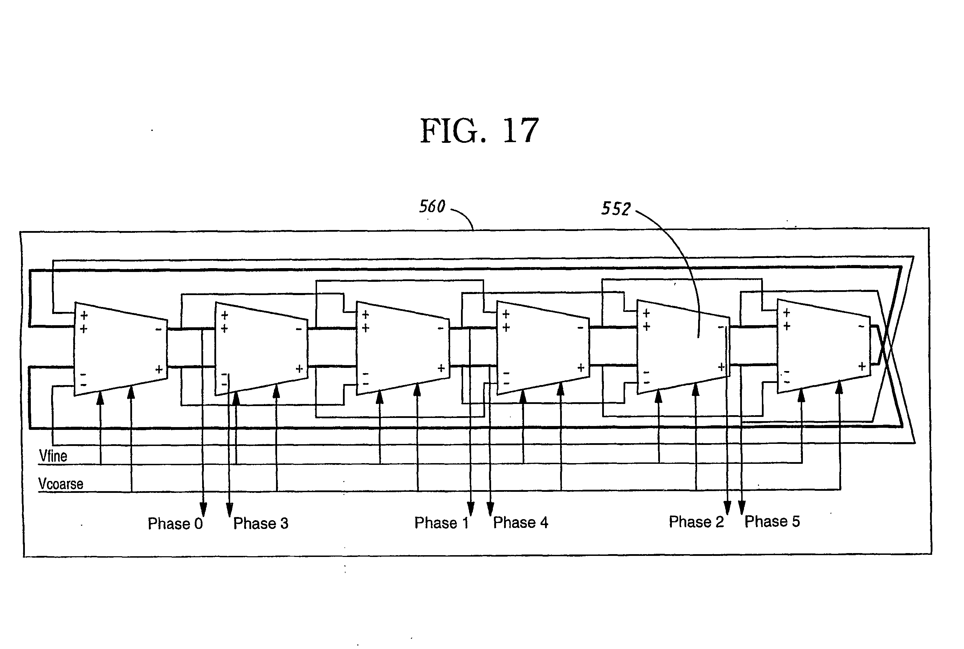

Figure 17 is a schematic of a receive six-stage VCO 550 structure of Figure 13 with dual delay paths, comprising six delay cells 552. The function of the dual delay path oscillator has been previously discussed with respect to the transmit VCO 418 and delay cells 440.

The phase rotator 506 of Figure 13 is an analog circuit and, as such, is a device allowing a step by step, glitch-free modulo shift of all n phases of the receive VCO 550 at the input to any phase angle at the output. The modulo option is guaranteeing phase and frequency compensation capability, the glitch-free performance assures that no bits are lost during rotation and 'step by step' means that the amount of phase change is limited to one phase slice for each clock cycle.

The concept of the phase rotator 506 is based on FIR filter principles. The receive VCO 550 may be seen as a circular array of delay elements. By multiplying the outputs t, n of the array with weighting factors m, n and summing the values, an FIR filter is built. The number of taps determine the amount of oversampling and, therefore, the order of an analog filter required for alias filtering. If the weighting factors may be changed dynamically, the FIR filter response may be changed 'on the fly'. This allows the dynamic adjustment of the output phase of such a filter.

It is preferred that the phase rotator 506 receive all six phases from the receive VCO 550 and provide a step by step shift to all six phases to any of 54 possible phase angles at the output. Thus, it will rotate all six phases in 6.67 degree steps which, for a 2.5 Gbit system, corresponds to 14.8ps. By taking specific weights of each phase, the phase rotator 506 outputs 6 shifted phases. The phases are generated in differential pairs and then passed through three stages of phase buffers 508 before entering the sampling latches 510. Each phase rotator 506 is controlled by 54 lines from logic, which adjust the current weights for each phase contribution.

The receive phase buffers 508 consist of circuits which are designed to interface to the output drive sections (all phases) of the phase rotator circuit 506 while subjecting the phase rotator 506 to only light loading. The phase buffers 508 then drive from the phase rotator 506 to the sampling latches 510 while providing the required input drive necessary for the phase rotator circuit 506. It is preferred that the receive phase buffers 508 operate at a rate necessary for a half rate design. It is also preferred that the phase buffers 508 provide adequate rise and fall times taking into account the estimated net loading.

The receive phase buffers 508 may include any circuits that drive clocks from sources to circuits that have high capacitive loading due to wiring and/or gate loading. For the receive PLL 501, it is preferred that the phase buffers 508 allow equal loading on the individual delay stages, and the drive capability to fan out the clock phases from a single PLL to four transmit/receive cores. At the clock rates used in the present embodiment, phase buffers 508 are important in assuring reasonable rise and fall times, duty cycle, and jitter performance of system clocks.

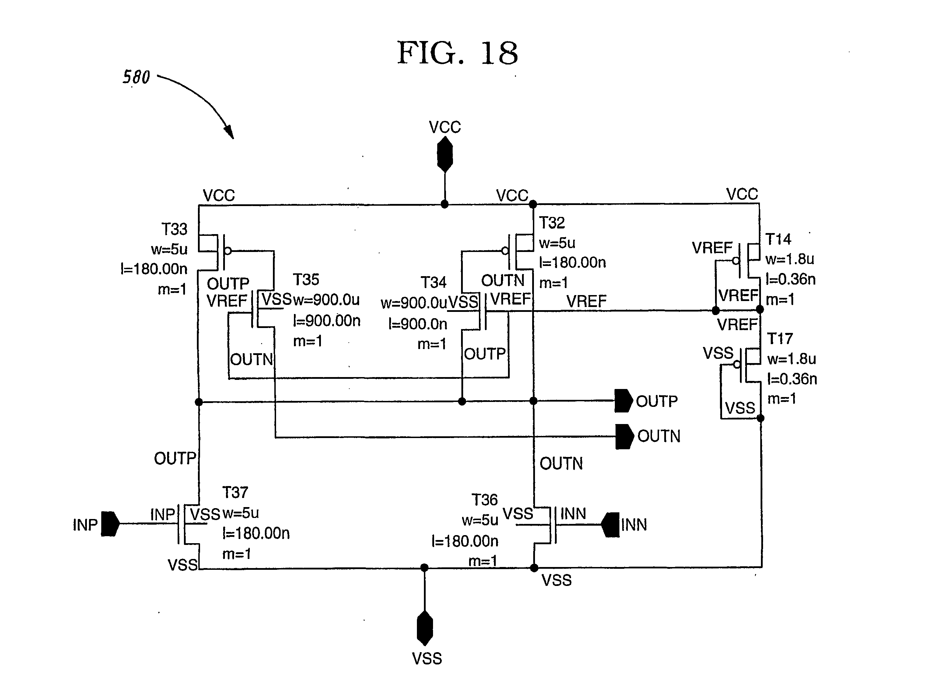

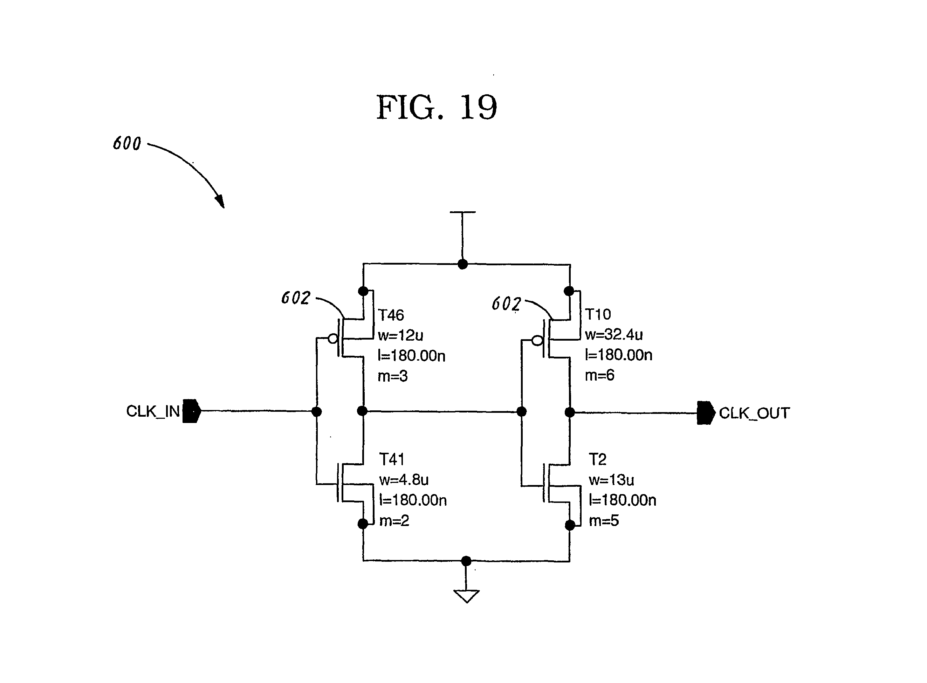

A preferred embodiment utilizes two phase buffer 508 circuit topologies. The first is a pseudo-differential positive feedback latching stage referred to as the latch buffer 580, shown in Figure 18. The second topology is simply a pair of inverters and referred to as the inverter buffer 500, shown in Figure 19. The two buffer types are used for different applications. For higher power, jitter critical paths, the latch buffer 580 is used because of the circuit's power supply rejection qualities. This includes buffering the differential phases coming out of the receive PLL circuit 501, going into the Phase Rotator 506, and coming out of the Phase Rotator 506. The inverter buffers 600 are used primarily to buffer single ended clocks to logic level circuits, including core logic and sampling latches 510.

Referring now to Figure 18, the latch buffer 580 operates with positive feedback through cross-coupling n-channel devices to provide a very fast transition. This is good for avoiding power supply noise because the transition timing is a function of the differential signal coming in. It avoids using just one of the single ended sides to determine when to transition (like an inverter stage would) and, therefore, avoids relying on the supply to be steady. One of the drawbacks of this circuit is the significant DC level of current usage that normal inverters do not have. Another drawback is the lack of a rail to rail output. In the embodiment shown, the p-channel devices are always on, therefore causing the down-level to only approach about 200mV.

Referring now to Figure 19, the inverter buffer 600 relies on using pairs of inverter stages 602 to track mismatches in p- to n-channel devices. This greatly improves jitter performance through the inverter stages 602. Whenever the inverter buffer 600 is used to ramp up the driving capability of a circuit, the general rule of exponentially increasing inverter sizes by the power of "e" was used. This keeps rise and fall times consistent through all stages of inverter chains. And since jitter is basically a linear function of rise and fall time, this prevented excessive jitter at any one stage. To maintain the duty-cycle of the clocks, the ratio of p- to n-channel was selected in the embodiment shown in Figure 19 to be 2.5 in order to match the approximate drive mismatch of the two devices in 7SF. It is preferred that the inverters are sized at a minimal length to maximize speed performance.

The phase buffers 508 characteristics are measured primarily by power usage and jitter. In most cases, it is preferential to trade off increased power usage for better jitter performance. Table 6 illustrates jitter and power numbers for exemplary embodiments of the Phase Buffers 472 and 508. The simulated jitter numbers were based on power supply noise. For the transmit Phase Buffers 472, the noise level was 75mVp-p. For the receive Phase Buffers 508, the noise level was 150mVp-p. All numbers are for 2.5 Gbps operation, on a per link basis.

**Table 6: XMT and RCV Phase Buffer Performance (at 2.5Gbps)**

| **Test Conditions** | **POWER SPEC** | **POWER SIM** | **JITTER SPEC** | **JITTER SIM** |
|---|---|---|---|---|
| RCV PB, ASICBC, 1.98V VCC, 0C | 6.6mW | 13.2mW | 8ps PP | 1.2ps PP |
| RCV PB, TYP, 1.8V VCC, 62.5C | | 9.2mW | | 2.6ps PP |
| RCV PB, ASICWC, 1.62V VCC, 125C | | 6.3mW | | 5.2ps PP |
| XMT PB, ASICBC, 1.98V VCC, 0C | 1.8MW | 6.8mW | 8ps PP | 6.8ps PP |
| XMT PB, TYP, 1.8V VCC, 62.5C | | 4.9mW | | 14.4ps PP |
| XMT PB, ASICWC, 1.62V VCC 125C | | 3.9mW | | 18.5ps PP |

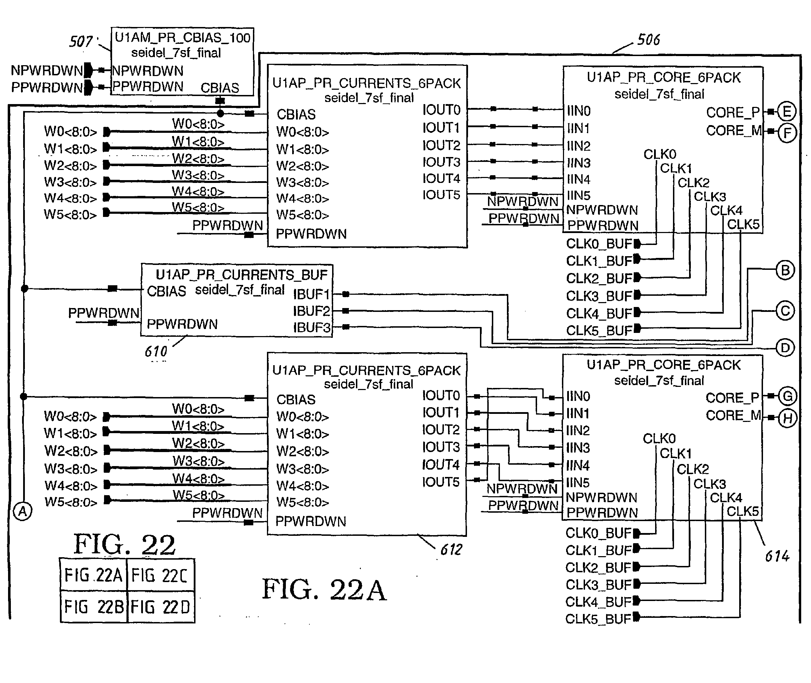

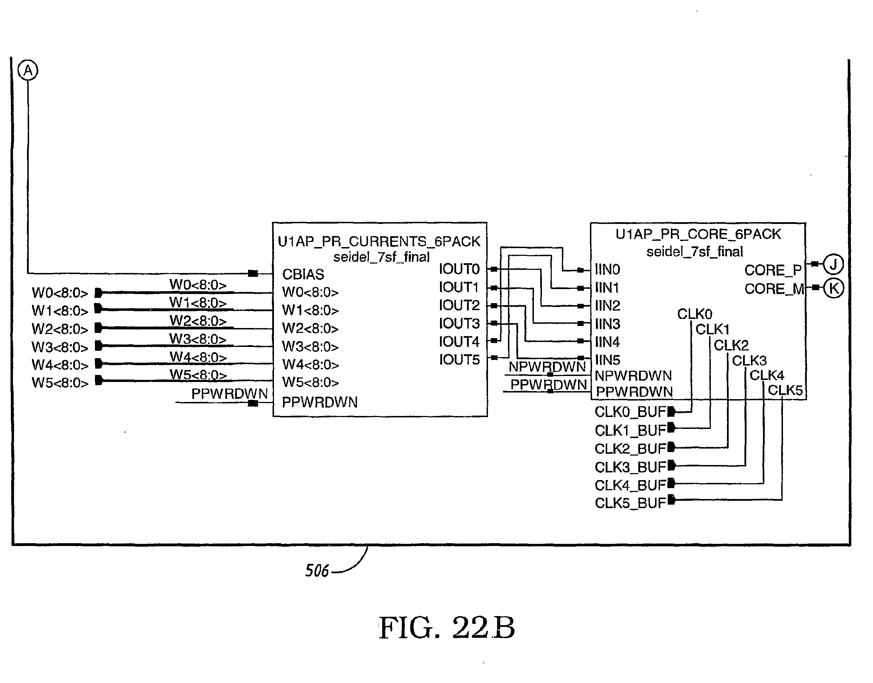

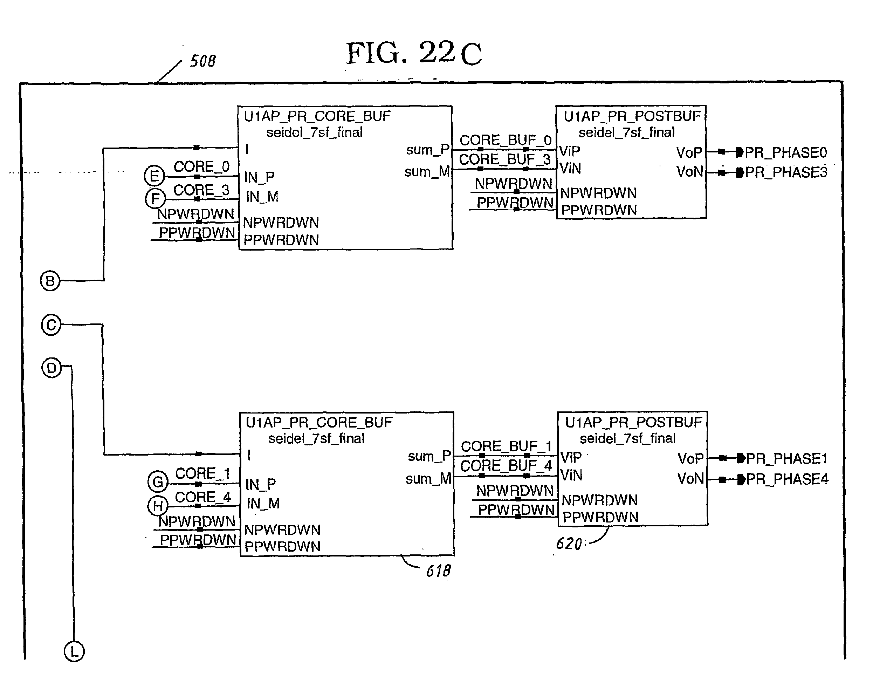

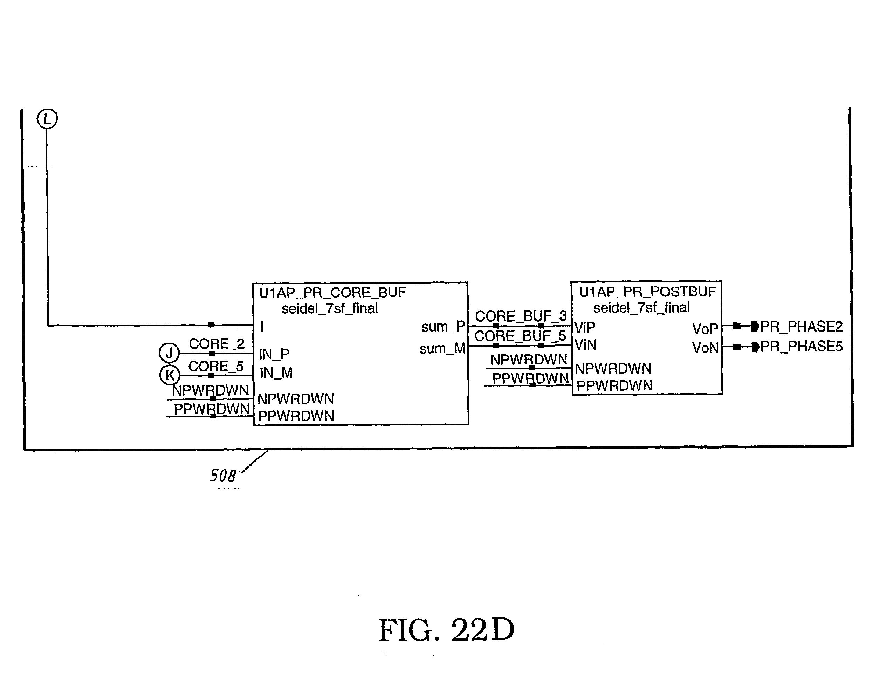

Referring now to Figure 22, a block diagram of the topography of an embodiment of the phase rotator circuits 506, associated cbias circuits 507 and phase buffer circuits 508 are shown. The phase rotator 506 comprises phase rotator currents buffer circuits 610, phase rotator current circuits 612 and phase rotator core circuits 614. The phase buffer circuits 508 comprise phase buffer core circuits 618 and phase buffer post-buffer circuits 620. The phase rotator circuits 506, associated cbias circuits 507 and phase buffer circuits 508 are more fully described in U.S. patent application, serial No. 09/861,668, filed May 22, 2001, by Schmatz, entitled "Phase Rotator and Data Recovery Receiver Incorporating said Phase Rotator", the entire disclosure of which is incorporated by reference herein. Schematic exemplary diagrams of elements of Figure 22 have been provided as follows.

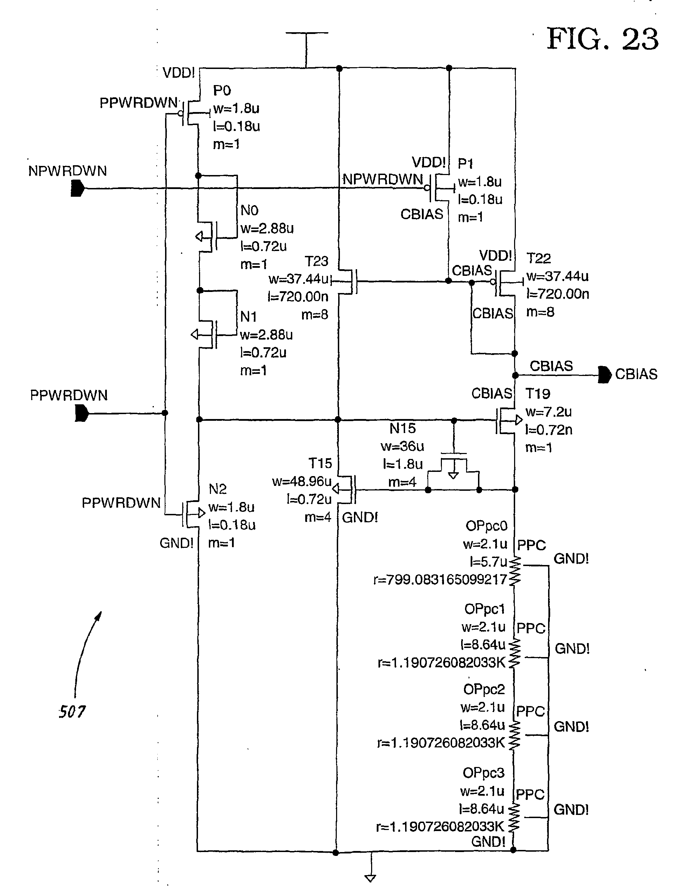

Figure 23 provides an exemplary schematic diagram of the phase rotator cbias circuit 507.

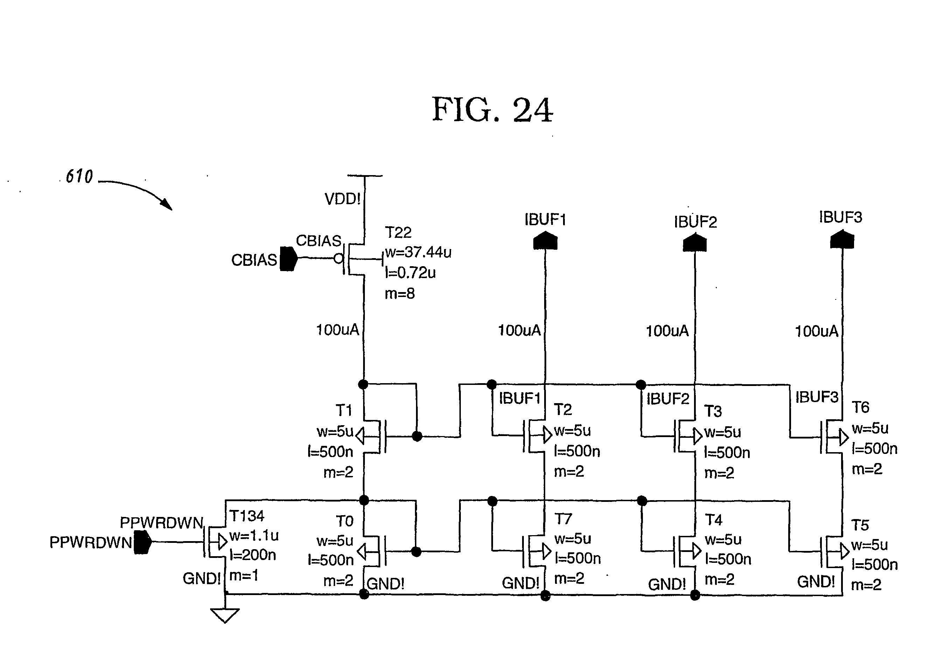

Figure 24 provides an exemplary schematic diagram of the phase rotator currents buffer circuit 610.

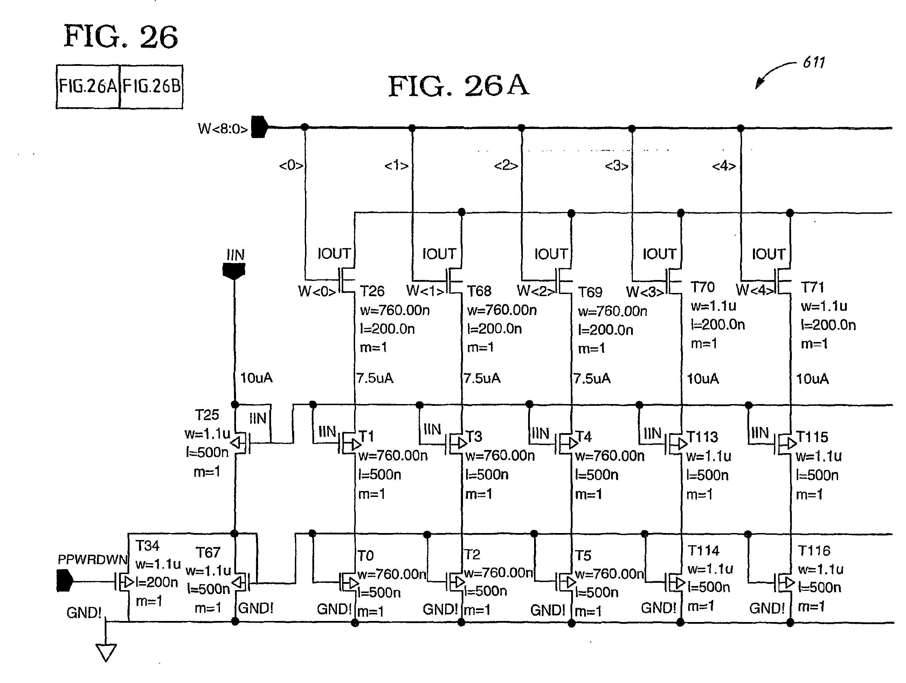

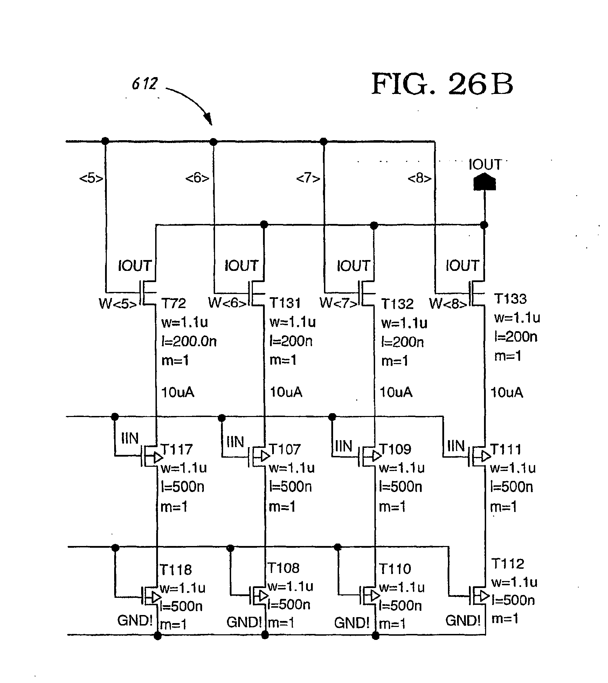

Figure 26 provides an exemplary schematic diagram of the phase rotator currents buffer circuit 612.

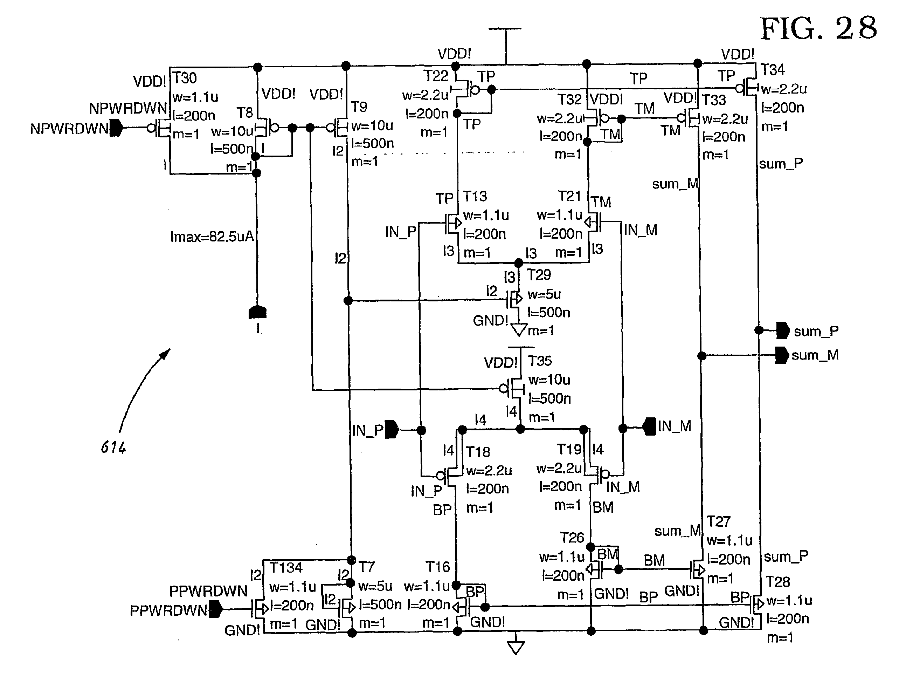

Figure 28 provides an exemplary schematic diagram of the phase rotator core circuit 614.

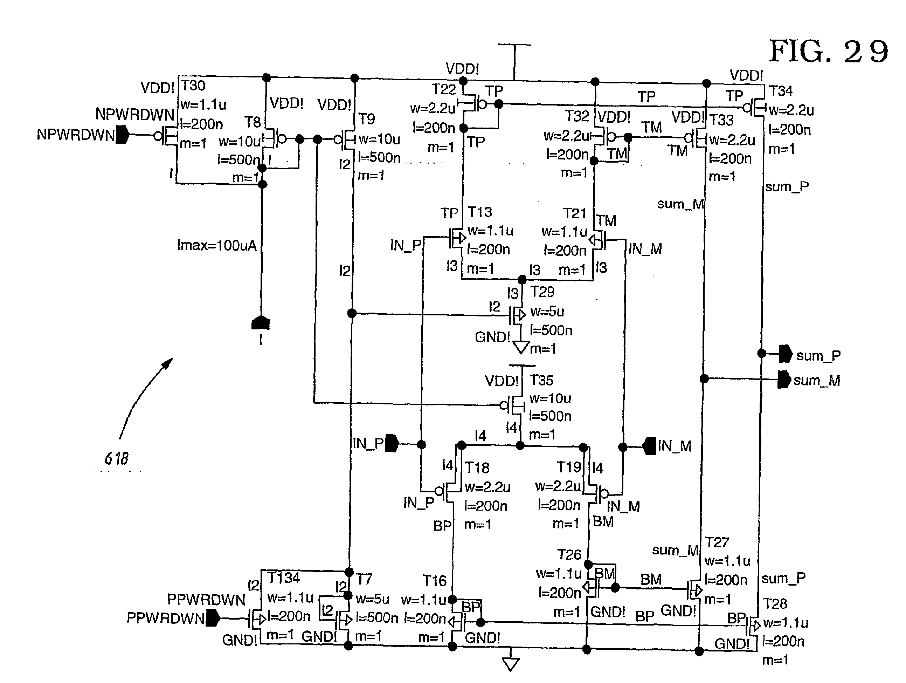

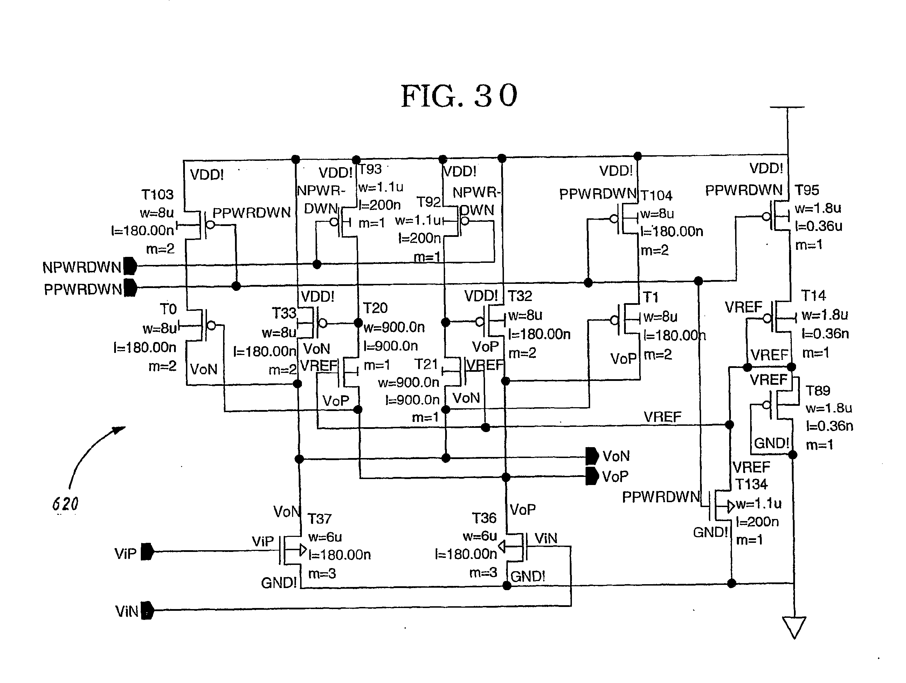

With respect to the phase buffer circuits 508, Figure 29 provides an exemplary schematic diagram of the phase rotator buffer core circuit 618, and Figure 30 provides an exemplary schematic diagram of the phase rotator buffer post-buffer circuit 620.

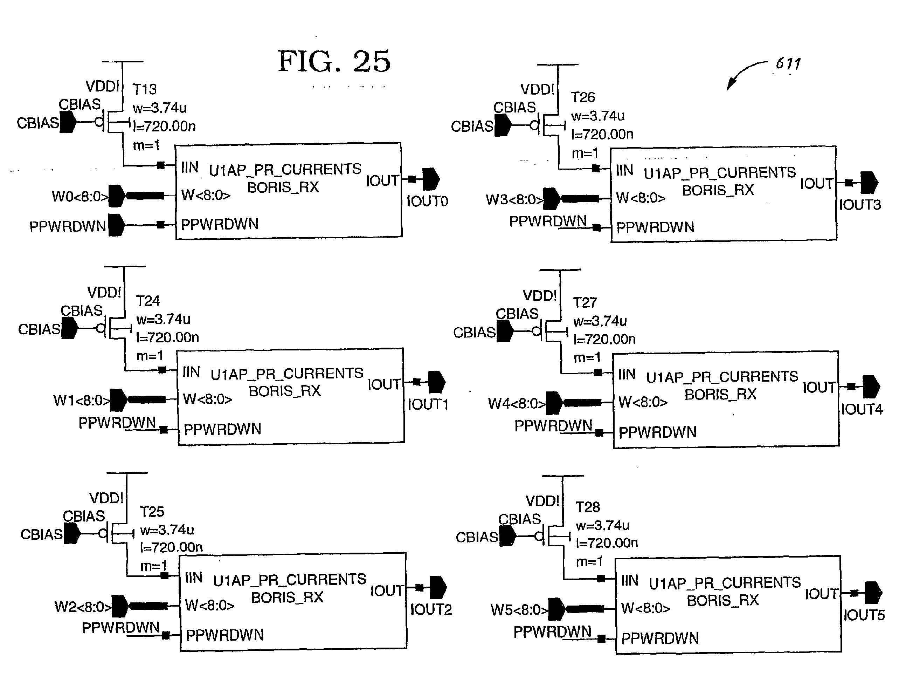

Block diagrams have also been provided to more clearly illustrate phase rotator 506 and phase buffer circuitry 508. Figure 25 is a block diagram of a phase rotator currents buffer 610 six pack 611.

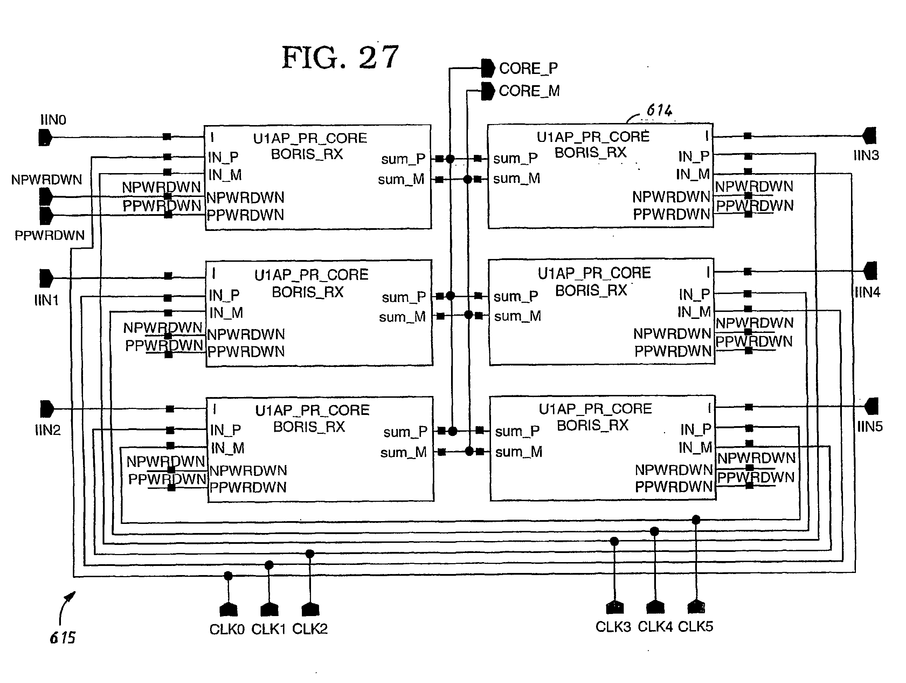

Figure 27 is a block diagram of a phase rotator core circuit 614 six pack 615.

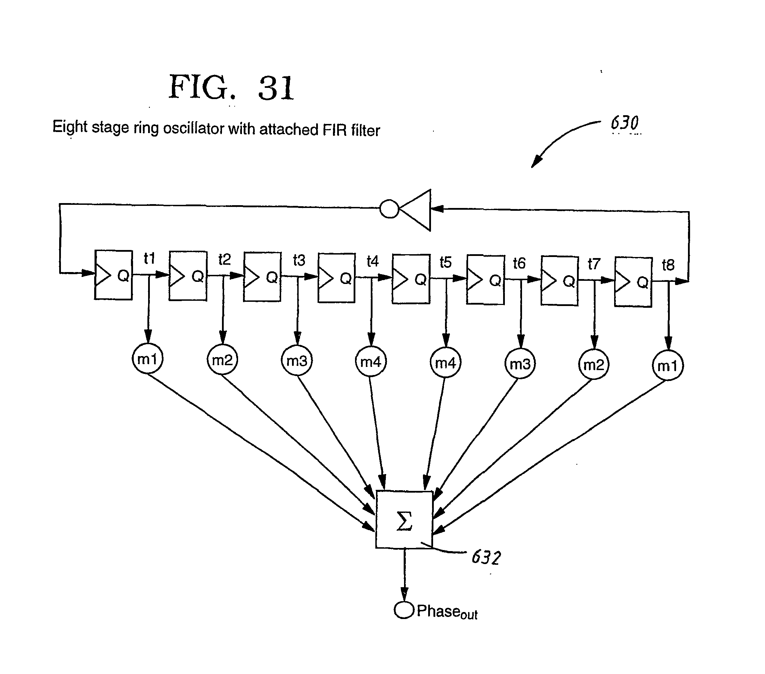

Figure 31 shows another embodiment featuring a basic FIR filter 632 approach with eight taps t1 to t8 from an eight stage/phase ring oscillator 630. Five different weighting factors m0 to m4 are assumed to be available, and they are built by summing sub-factors w1 to w4. Table 7 shows the initial configuration for the weighting factors.

**Table 7: Configuration of the weighting factors m0 to m4 from sub-factors 21 to w4**

| **Weighting factor** | **Configuration** |
|---|---|
| m0 | = 0 (not used in initial configuration) |
| m1 | = w1 |
| m2 | = w1 + w2 |
| m3 | = w1 + w2 + w3 |
| m4 | = w1 + w2 + w3 + w4 |

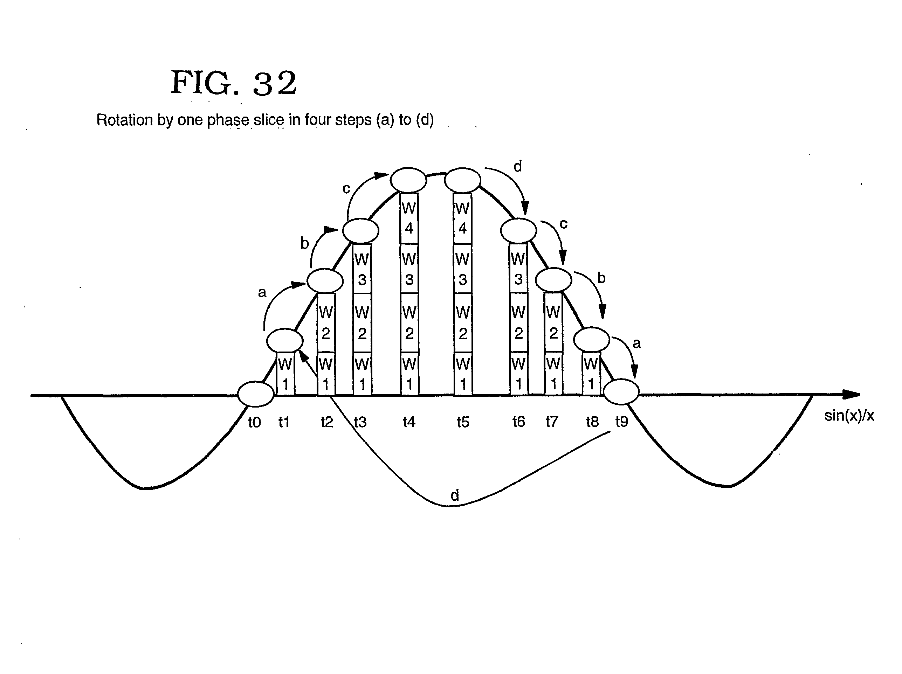

Figure 32 shows the stepwise change of output phase by sequentially changing the weighting factors that determine the contribution from each phase tap to the actual output. In step (a), for example, the weighting factor at tap t1 is changed from w1 to w1+w2 and, at the same time, the weight at tap t8 is changed to zero. For a 'clever' setting of the weight values w1 to w4, this will shift the output phase by exactly one-fourth of a phase slice. After the last rotating step (d), all weights have been shifted by one tap position. This corresponds to a shift of one phase slice at the output of the FIR.

By repetition of the above sequence, any phase setting may be tuned in. Because this is a circular operation, the range of the output phase is not limited to the 0 to 360 degree interval. This allows a continuous variation of the phase and thereby a frequency adjustment. Due to the fact that the weighting factors are only changed by adding or subtracting one sub-factor element at a time, no glitches can occur.

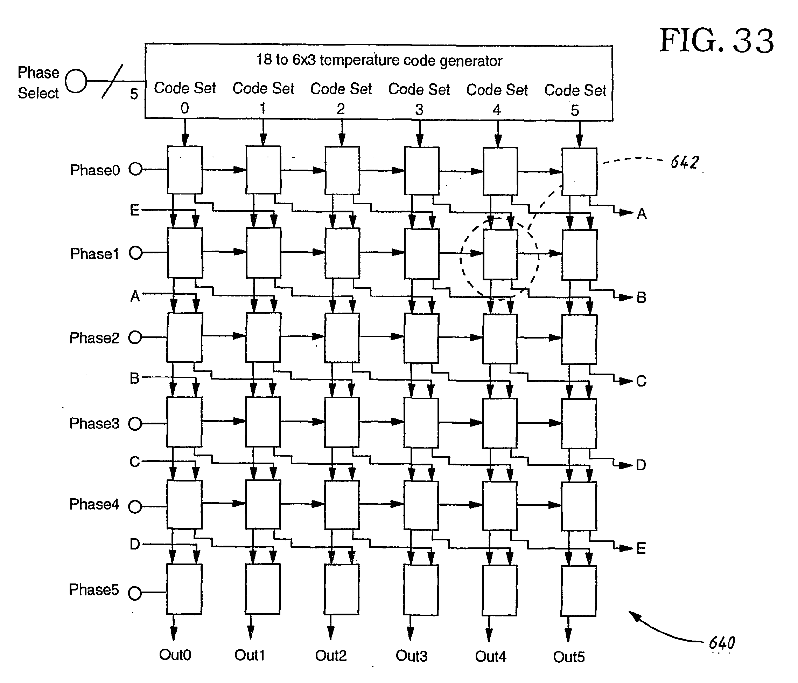

A simplified schematic for a six-phase phase rotator 640 according to the present invention is provided in Figure 33. With six-phase slices, four possible weighting factors m0 to m3 are built by variable summation of the three sub-factors w0 to w2. A temperature code logic generates the control signals for the wired summation of currents. This allows the generation of eighteen phase steps for one 360 degree rotation from a three stage differential ring oscillator. The output of the FIR blocks are preferably summed by a wired n-function. In order to generate high quality clock signals, it is preferred that differential clock buffers are used.

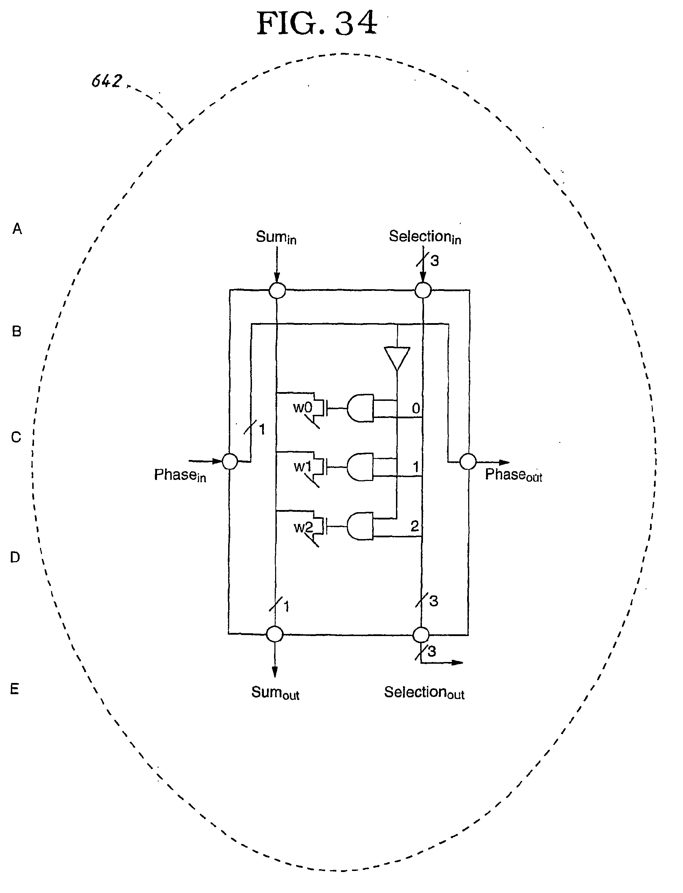

Figure 34 provides a detail view of one of the phase rotator circuit blocks 642 of Figure 33.

While preferred embodiments have been described herein, variations in the design may be made, and such variations may be apparent to those skilled in the art of making tools, as well as to those skilled in other arts. The performance and signal specifications identified above are by no means the only specifications suitable for the method and system of the present invention, and substitute specifications will be readily apparent to one skilled in the art. The scope of the invention, therefore, is only to be limited by the following claims.

## Claims

1. A serial link system for transmitting digital data across wired media including a transmitter and a receiver,
the receiver comprising: a phase locked loop (receiver PLL) (310) including a voltage controlled oscillator (550) providing a half-rate clock for oversampling the received data; a multi-step phase rotator (312) adapted to receive the output phases of the voltage controlled oscillator; a signal edge comparator (318) for detecting edges of the received data; and a signal generator (324, 326) for generating an early/late signal based on the output of the edge comparator for use in controlling said multi-step phase rotator;
**characterised by**
the transmitter comprising a dual loop phase locked loop control circuit (transmitter PLL) having a digital coarse loop (460, 462, 464, 468) for providing a PLL frequency control signal to an analog fine loop (427), the analog fine loop providing a stable clock for transmitting the digital data.

2. A system according to claim 1 wherein the transmitter PLL is adapted to operate at full data rate and contains a four-stage voltage controlled oscillator adapted to run at full bit frequency.

3. A system according to claim 1 or 2 including a frequency reference clock that runs at one-fourth of the full data rate, and a comparator that compares the frequency of the transmitter PLL with the frequency of the reference clock.

4. A system according to any of claims 1 to 3 wherein said digital coarse loop includes a reference generator (460), a voltage comparator (462), a PLL control logic (464), a digital to analog converter (466) and a low pass filter (468).

5. A system according to any preceding claim, wherein each of the transmitter PLL and the receiver PLL contains a pseudo random bit stream generator and checker for wrap mode self-testing.

6. A system according to any preceding claim wherein the receiver includes a bit edge correlation table for generating early and late signals

7. A system according to claim 6 including a phase rotator control state machine for processing the early and late signals from the correlation table to control the phase settings of said multi-step phase rotator.

8. A system according to claim 7 wherein said multi-step phase rotator is independent of the receiver PLL, and is provided for the purpose of making phase adjustments and clock recovery.

9. A system according to claim 1 wherein the receiver PLL is arranged to control the voltage controlled oscillator, and the output phases of the oscillator are connected to said multi-step phase rotator.

10. A method of transmitting digital data across wired media between a transmitter and a receiver, comprising:
providing a receiver comprising: a phase locked loop (receiver PLL) (310) including a voltage controlled oscillator (550) providing a half-rate clock for oversampling the received data; a multi-step phase rotator (312) adapted to receive the output phases of the voltage controlled oscillator; a signal edge comparator (318) for detecting edges of the received data; and a signal generator (324, 326) for generating an early/late signal based on the output of the edge comparator for use in controlling said multi-step phase rotator; **characterised by**
providing a transmitter with a phase locked loop control circuit ( transmitter PLL) having a digital coarse loop and an analog fine loop (427);
providing a PLL frequency control signal from the coarse loop to an analog fine loop, the analog fine loop providing a stable clock for transmitting the digital data.

11. A method according to claim 10 wherein the transmitter PLL operates at full data rate and contains a four-stage voltage controlled oscillator running at full bit frequency.

12. A method according to claim 10 or 11 including a frequency reference clock that runs at one-fourth of the full data rate, and a comparator that compares the frequency of the transmitter PLL with the frequency of the reference clock.

13. A method according to any of claims 10 to 12 wherein said digital PLL coarse loop further utilizes a reference generator, a voltage comparator, a PLL control logic, a digital to analog converter and a low pass filter.

14. A method according to any of claims 10 to 13 wherein each of the transmitter PLL and the receiver PLL uses a pseudo random bit stream generator and checker for wrap mode self-testing.

15. A method according to any of claims 10 to 14 wherein the receiver uses a bit edge correlation table for generating early and late signals.

16. A method according to claim 15 wherein a phase rotator control state machine processes the early and late signals from the correlation table to control the phase settings of said multi-step phase rotator.

17. A method according to claim 16 wherein said multi-step phase rotator is independent of the receiver PLL, and is employed for the purpose of making phase adjustments and clock recovery.

18. A method according to any of claims 10 to 17 wherein the receiver PLL controls a voltage controlled oscillator, and the output phases of the oscillator are fed to said multi-step phase rotator.

## Patentansprüche

1. Serielles Verbindungssystem zum Übertragen digitaler Daten über leitungsgestützte Medien mit einem Sender und einem Empfänger;
wobei der Empfänger Folgendes umfasst: eine Phasenregelschleife (Empfänger-PLL) (310) mit einem spannungsgesteuerten Oszillator (550), der einen Halbratentakt zum Überabtasten der empfangenen Daten bereitstellt; einen Mehrschritt-Phasenrotator (312), der eingerichtet ist, die Ausgangsphasen des spannungsgesteuerten Oszillators zu empfangen; einen Signalflankenkomparator (318) zum Erfassen von Flanken der empfangenen Daten; und einen Signalgenerator (324, 326) zum Erzeugen eines Früh-/Spät-Signals anhand des Ausgangs des Flankenkomparators zur Verwendung bei der Steuerung des Mehrschritt-Phasenrotators; **dadurch gekennzeichnet, dass**:
der Sender eine Zweischleifen-Phasenregelschleife-Steuerschaltung (Sender-PLL) enthält, die eine digitale Grobschleife (460, 462, 464, 648) zum Bereitstellen eines PLL-Frequenzsteuersignals an eine analoge Feinschleife (427) aufweist, wobei die analoge Feinschleife einen stabilen Takt zum Übertragen der digitalen Daten bereitstellt.

2. System nach Anspruch 1, wobei der Sender-PLL eingerichtet ist, bei der vollen Datenrate betrieben zu werden und einen vierstufigen spannungsgesteuerten Oszillator enthält, der eingerichtet ist, bei der vollen Bitfrequenz zu laufen.

3. System nach Anspruch 1 oder 2, mit einem Frequenzreferenztakt, der bei einem Viertel der vollen Datenrate läuft, und einem Komparator, der die Frequenz des Sender-PLL mit der Frequenz des Referenztakts vergleicht.

4. System nach einem der Ansprüche 1 bis 3, wobei die digitale Grobschleife einen Referenzgenerator (460), einen Spannungskomparator (462), eine PLL-Steuerlogik (454), einen Digital-/Analog-Umsetzer (466) und ein Tiefpassfilter (468) enthält.

5. System nach einem der vorhergehenden Ansprüche, wobei der Sender-PLL und der Empfänger-PLL jeweils einen Pseudo-Zufallsbitstrom-Generator und eine Prüfeinrichtung für eine Umlaufmodus-Selbstprüfung enthalten.

6. System nach einem der vorhergehenden Ansprüche, wobei der Empfänger eine Bitflanken-Korrelationstabelle zum Erzeugen von Früh- und Spät-Signalen enthält.

7. System nach Anspruch 6, das eine Phasenrotatorsteuerungs-Zustandsmaschine zum Verarbeiten der Früh- und Spät-Signale aus der Korrelationstabelle enthält, um die Phaseneinstellungen des Mehrschritt-Phasenrotators zu steuern.

8. System nach Anspruch 7, wobei der Mehrschritt-Phasenrotator von dem Empfänger-PLL unabhängig ist und für Phaseneinstellungen und zur Taktgewinnung vorgesehen ist.

9. System nach Anspruch 1, wobei der Empfänger-PLL eingerichtet ist, den spannungsgesteuerten Oszillator zu steuern, wobei die Ausgangsphasen des Oszillators mit dem Mehrschritt-Phasenrotator verbunden sind.

10. Verfahren zum Senden digitaler Daten über leitungsgestützte Medien zwischen einem Sender und einem Empfänger, das folgende Schritte umfasst:
Bereitstellen eines Empfängers, der Folgendes umfasst:
eine Phasenregelschleife (Empfänger-PLL) (310) mit einem spannungsgesteuerten Oszillator (550), der einen Halbratentakt zum Überabtasten der empfangenen Daten bereitstellt; einen Mehrschritt-Phasenrotator (312) der eingerichtet ist, die Ausgangsphase des spannungsgesteuerten Oszillators zu empfangen; einen Signalflankenkomparator (318) zum Erfassen von Flanken der empfangenen Daten; und einen Signalgenerator (324, 325) zum Erzeugen eines Früh-/Spät-Signals anhand des Ausgangs des Flankenkomparators zur Verwendung bei der Steuerung des Mehrschritt-Phasenrotators, **gekennzeichnet durch** die folgenden Schritte:
Bereitstellen eines Senders mit einer Phasenregelschleife-Steuerschaltung (Sender-PLL), die eine digitale Grobschleife und eine analoge Feinschleife (427) aufweist; und
Bereitstellen eines PLL-Frequenzsteuersignals von der Grobschleife an eine analoge Feinschleife, wobei die analoge Feinschleife einen stabilen Takt zum Senden der digitalen Daten bereitstellt.

11. Verfahren nach Anspruch 10, wobei der Sender-PLL bei einer vollen Datenrate betrieben wird und einen vierstufigen spannungsgesteuerten Oszillator, der bei einer vollen Bitfrequenz läuft, enthält.

12. Verfahren nach Anspruch 10 oder 11 mit einem Frequenzreferenztakt, der bei einem Viertel der vollen Datenrate läuft, und einem Komparator, der die Frequenz des Sender-PLL mit der Frequenz des Referenztakts vergleicht.

13. Verfahren nach einem der Ansprüche 10 bis 12, wobei die digitale PLL-Grobschleife einen Referenzgenerator, einen Spannungskomparator, eine PLL-Steuerlogik, einen Digital-/Analog-Umsetzer und ein Tiefpassfilter verwendet.

14. Verfahren nach einem der Ansprüche 10 bis 13, wobei der Sender-PLL und der Empfänger-PLL jeweils einen Pseudo-Zufallsbitstromgenerator und eine Prüfeinrichtung für eine Umlaufmodus-Selbstprüfung verwenden.

15. Verfahren nach einem der Ansprüche 10 bis 14, wobei der Empfänger eine Bitflanken-Korrelationstabelle zum Erzeugen von Früh- und Spät-Signalen verwendet.

16. Verfahren nach Anspruch 15, wobei eine Phasenrotatorsteuerungs-Zustandsmaschine die Früh- und Spät-Signale von der Korrelationstabelle verarbeitet, um die Phaseneinstellung des Mehrschritt-Phasenrotators zu steuern.

17. Verfahren nach Anspruch 16, wobei der Mehrschritt-Phasenrotator von dem Empfänger-PLL unabhängig ist und für Phaseneinstellungen und zur Taktgewinnung verwendet wird.

18. Verfahren nach einem der Ansprüche 10 bis 17, wobei der Empfänger-PLL einen spannungsgesteuerten Oszillator steuert und die Ausgangsphasen des Oszillators zum Mehrschritt-Phasenrotator geleitet werden.

## Revendications

1. Système de liaison série destiné à transmettre des données numériques sur des supports câblés comprenant un émetteur et un récepteur,
le récepteur comprenant : une boucle à verrouillage de phase (boucle à verrouillage de phase du récepteur) (310) comprenant un oscillateur commandé en tension (550) fournissant une horloge à demi-fréquence afin de sur-échantillonner les données reçues, un module de rotation de phase à pas multiples (312) conçu pour recevoir les phases de sortie de l'oscillateur commandé en tension, un comparateur de fronts de signaux (318) destiné à détecter les fronts des données reçues, et un générateur de signaux (324, 326) destiné à générer un signal en avance/en retard sur la base de la sortie du comparateur de fronts en vue d'une utilisation pour commander ledit module de rotation de phase à pas multiples, **caractérisé par le fait que** :
l'émetteur comprend un circuit de commande de boucle à verrouillage de phase à boucle double (boucle à verrouillage de phase de l'émetteur) comportant une boucle grossière numérique (460, 462, 464, 468) destinée à fournir un signal de commande de fréquence de boucle à verrouillage de phase à une boucle fine analogique (427), la boucle fine analogique fournissant une horloge stable pour émettre les données numériques.

2. Système selon la revendication 1, dans lequel la boucle à verrouillage de phase de l'émetteur est conçue pour fonctionner à un débit de données complet et contient un oscillateur commandé en tension à quatre étages conçu pour fonctionner à la fréquence binaire complète.

3. Système selon la revendication 1 ou 2, comprenant une horloge de référence de fréquence qui fonctionne à un quart du débit de données complet et un comparateur qui compare la fréquence de la boucle à verrouillage de phase de l'émetteur à la fréquence de l'horloge de référence.

4. Système selon l'une quelconque des revendications 1 à 3, dans lequel ladite boucle grossière numérique comprend un générateur de référence (460), un comparateur de tension (462), une logique de commande de boucle à verrouillage de phase (464), un convertisseur de numérique en analogique (466) et un filtre passe-bas (468).

5. Système selon l'une quelconque des revendications précédentes, dans lequel chacune de la boucle à verrouillage de phase de l'émetteur et de la boucle à verrouillage de phase du récepteur contient un générateur de flux binaire pseudo aléatoire et un module de vérification d'autotest de mode d'essai en boucle.

6. Système selon l'une quelconque des revendications précédentes, dans lequel le récepteur comprend une table de corrélation de front de bit destinée à générer des signaux en avance et en retard.

7. Système selon la revendication 6, comprenant une machine à états finis de commande de module de rotation de phase destinée à traiter les signaux en avance et en retard provenant de la table de corrélation pour commander les réglages de phase du module de rotation de phase à pas multiples.

8. Système selon la revendication 7, dans lequel ledit module de rotation de phase à pas multiples est indépendant de la boucle à verrouillage de phase du récepteur, et est prévu dans le but d'effectuer des réglages de phase et la récupération d'horloge.

9. Système selon la revendication 1, dans lequel la boucle à verrouillage de phase du récepteur est conçue pour commander l'oscillateur commandé en tension et les phases de sortie de l'oscillateur sont reliées audit module de rotation de phase à pas multiples.

10. Procédé de transmission de données numériques sur des supports câblés entre un émetteur et un récepteur comprenant le fait de :
fournir un récepteur comprenant : une boucle à verrouillage de phase (boucle à verrouillage de phase du récepteur) (310) comprenant un oscillateur commandé en tension (550) fournissant une horloge à demi-fréquence afin de sur-échantillonner les données reçues, un module de rotation de phase à pas multiples (312) conçu pour recevoir les phases de sortie de l'oscillateur commandé en tension, un comparateur de fronts de signaux (318) destiné à détecter les fronts des données reçues, et un générateur de signaux (324, 326) destiné à générer un signal en avance/en retard sur la base de la sortie du comparateur de fronts à utiliser pour commander ledit module de rotation de phase à pas multiples, **caractérisé par**
le fait de prévoir un émetteur comportant un circuit de commande de boucle à verrouillage de phase (boucle à verrouillage de phase de l'émetteur) comportant une boucle grossière numérique et une boucle fine analogique (427),
le fait de fournir un signal de commande de fréquence de boucle à verrouillage de phase de la boucle grossière à une boucle analogique fine, la boucle analogique fine fournissant une horloge stable pour transmettre les données numériques.

11. Procédé selon la revendication 10, dans lequel la boucle à verrouillage de phase de l'émetteur fonctionne à un débit de données complet et contient un oscillateur commandé en tension à quatre étages fonctionnant à une fréquence binaire complète.

12. Procédé selon la revendication 10 ou 11, comprenant une horloge de référence de fréquence qui fonctionne à un quart du débit de données complet et un comparateur qui compare la fréquence de la boucle à verrouillage de phase de l'émetteur à la fréquence de l'horloge de référence.

13. Procédé selon l'une quelconque des revendications 10 à 12, dans lequel ladite boucle grossière numérique de boucle à verrouillage de phase utilise en outre un générateur de référence, un comparateur de tension, une logique de commande de boucle à verrouillage de phase, un convertisseur de numérique en analogique et un filtre passe-bas.

14. Procédé selon l'une quelconque des revendications 10 à 13, dans lequel chacune de la boucle à verrouillage de phase de l'émetteur et de la boucle à verrouillage de phase du récepteur utilise un générateur de flux binaire pseudo-aléatoire et un module de contrôle destiné à un test automatique de mode d'essai en boucle.

15. Procédé selon l'une quelconque des revendications 10 à 14, dans lequel le récepteur utilise une table de corrélation de front de bit destinée à générer des signaux en avance et en retard.

16. Procédé selon la revendication 15, dans lequel une machine à états finis de commande de module de rotation de phase traite les signaux en avance et en retard provenant de la table de corrélation pour commander les réglages de phases dudit module de rotation de phase à pas multiples.

17. Procédé selon la revendication 16, dans lequel ledit module de rotation de phase à pas multiples est indépendant de la boucle à verrouillage de phase du récepteur, et est employé dans le but de réaliser les réglages de phase et la récupération d'horloge.

18. Procédé selon l'une quelconque des revendications 10 à 17, dans lequel la boucle à verrouillage de phase du récepteur commande un oscillateur commandé en tension, et les phases de sortie de l'oscillateur sont appliquées en entrée audit module de rotation de phase à pas multiples.
